# EUROPEAN PATENT APPLICATION

(11) **EP 4 770 417 A2**
(43) Date of publication of application: **01.07.2026**
(21) Application number: 25218150.8
(22) Date of filing: 24.11.2025
(51) Int. Cl.: H10W 90/20, H10W 90/28, H10W 90/00

(54) **POWER AMPLIFIER ASSEMBLIES AND MULTIPLE-STAGE AMPLIFIER SYSTEMS**

(30) Priority: 03.12.2024 US 202418966526
(71) Applicant: NXP USA, Inc., Austin, TX 78735 (US)
(72) Inventor: KHALIL, Ibrahim, 5656AG Eindhoven (NL); JONES, Jeffrey Kevin, 5656AG Eindhoven (NL); van STRATEN, Freek Egbert, 5656AG Eindhoven (NL)
(74) Representative: Schwarzweller, Thomas

(57) **Abstract**

Power amplifier assemblies and multiple-stage amplifier systems include first and second semiconductor dies, each of which includes an integrated transistor. The second semiconductor die is physically and electrically coupled to a die-mounting interface at a mounting surface of the first semiconductor die in a "flip-chip" orientation. This arrangement provides a multiple-stage amplifier that includes the integrated transistor of the first semiconductor die coupled in a cascade arrangement with the integrated transistor of the second semiconductor die. The first and second semiconductor dies may be formed from different semiconductor materials.

## Description

### TECHNICAL FIELD

The present invention relates generally to multiple-stage amplifier systems. More specifically, the present invention relates to amplifier systems with multiple power amplifiers realized with transistors in multiple semiconductor dies.

### BACKGROUND

A multiple-stage power amplifier typically includes an amplifier substrate (e.g., a printed circuit board (PCB)) and multiple, transistor-bearing semiconductor dies (e.g., one die for each of the multiple amplification stages) coupled to a mounting surface of the amplifier substrate. When two amplification stages are coupled in a cascade arrangement, the output (e.g., drain terminal) of a first transistor in a first semiconductor die is electrically coupled through the amplifier substrate to the input (e.g., gate terminal) of a second transistor in a second semiconductor die. In some cases, the amplifier substrate also may support an impedance matching circuit between the first transistor output and the second transistor input. To extract heat from the semiconductor dies during operation, the dies may be connected to thermally-conducting "coins" or thermal vias in the amplifier substrate.

The overall size (e.g., footprint) of a multiple-stage amplifier includes the PCB areas occupied by the multiple semiconductor dies and the impedance matching circuit, if included, plus the area occupied by any additional circuitry associated with the amplifier (e.g., bias circuits, input/output connectors, and so on). With the ever-present trend towards miniaturization, amplifier designers strive to develop multiple-stage amplifiers and heat dissipation systems that occupy less area without sacrificing performance.

### BRIEF DESCRIPTION OF THE DRAWINGS

The accompanying figures in which like reference numerals refer to identical or functionally similar elements throughout the separate views, the figures are not necessarily drawn to scale, and which together with the detailed description below are incorporated in and form part of the specification, serve to further illustrate various embodiments and to explain various principles and advantages all in accordance with the present invention.
FIG. 1 illustrates a top view of a power amplifier assembly, according to an embodiment;
FIG. 2A illustrates a side, cross-sectional view of the power amplifier assembly of FIG. 1 along line 2-2, according to an embodiment;
FIG. 2B illustrates a side, cross-sectional view of the power amplifier assembly of FIG. 1 along line 2-2, according to another embodiment;
FIG. 2C illustrates a side, cross-sectional view of the power amplifier assembly of FIG. 1 along line 2-2, according to yet another embodiment;
FIG. 3 illustrates a top view of a power amplifier assembly, according to another embodiment;
FIG. 4A illustrates a side, cross-sectional view of the power amplifier assembly of FIG. 3 along line 4-4, according to an embodiment;
FIG. 4B illustrates a side, cross-sectional view of the power amplifier assembly of FIG. 3 along line 4-4, according to another embodiment;
FIG. 4C illustrates a side, cross-sectional view of the power amplifier assembly of FIG. 3 along line 4-4, according to yet another embodiment;
FIG. 5A illustrates a top view of a first semiconductor die of the power amplifier assembly of FIGs 1 or 3, according to an embodiment;
FIG. 5B illustrates a top view of a first semiconductor die of the power amplifier assembly of FIGs 1 or 3, according to another embodiment;
FIG. 6A illustrates a top view of a second semiconductor die of the power amplifier assembly of FIGs 1 or 3, according to an embodiment;
FIG. 6B illustrates a top view of a second semiconductor die of the power amplifier assembly of FIGs 1 or 3, according to another embodiment;
FIG. 7A illustrates a side, cross-sectional view of the second semiconductor die of FIG. 6A along line 7A-7A, according to an embodiment;
FIG. 7B illustrates a side, cross-sectional view of the second semiconductor die of FIG. 6B along line 7B-7B, according to an embodiment;
FIG. 8 illustrates a top view of a multiple-stage amplifier system, according to an embodiment;
FIG. 9 illustrates a top view of a multiple-stage amplifier system, according to another embodiment;
FIG. 10 is a top view of a Doherty power amplifier module that includes a first power amplifier assembly for the carrier amplifier and a second power amplifier assembly for the peaking amplifier, according to an embodiment;
FIG. 11 is a top view of a Doherty power amplifier that includes a two-input, two-output driver power amplifier assembly, according to an embodiment;
FIG. 12 illustrates a side, cross-sectional view of a multiple-stage amplifier system with a top-side cooling arrangement, according to an embodiment;
FIG. 13 illustrates a side, cross-sectional view of a multiple-stage amplifier system with a top-side cooling arrangement, according to another embodiment; and
FIG. 14 illustrates a side, cross-sectional view of a multiple-stage amplifier system with a bottom-side cooling arrangement, according to another embodiment.

### DETAILED DESCRIPTION

In overview, embodiments disclosed herein include power amplifier assemblies and multiple-stage amplifier systems that include first and second semiconductor dies, each of which includes an integrated transistor. The second semiconductor die is physically and electrically coupled to a die-mounting interface at a mounting surface of the first semiconductor die in a "flip-chip" orientation. This arrangement provides a compact multiple-stage amplifier that includes the integrated transistor of the first semiconductor die coupled in a cascade arrangement with the integrated transistor of the second semiconductor die. The first and second semiconductor dies may be formed from different semiconductor materials, in some embodiments, although they may be formed from the same semiconductor material, in other embodiments.

The power amplifier assemblies of the various embodiments described herein may have certain technical advantages over conventional multiple-stage power amplifiers. For example, the power amplifier assemblies of the various embodiments may include multiple amplification stages that consume significantly smaller areas (i.e., have significantly smaller footprints) on a system substrate than is needed for conventional multiple-stage power amplifiers. Additionally, as will be described in detail later, the power amplifier assemblies of the various embodiments are suitable for attachment to both top-side and bottom-side cooling structures, which may be desirable in that a given type of cooling structure may enable overall system size reductions.

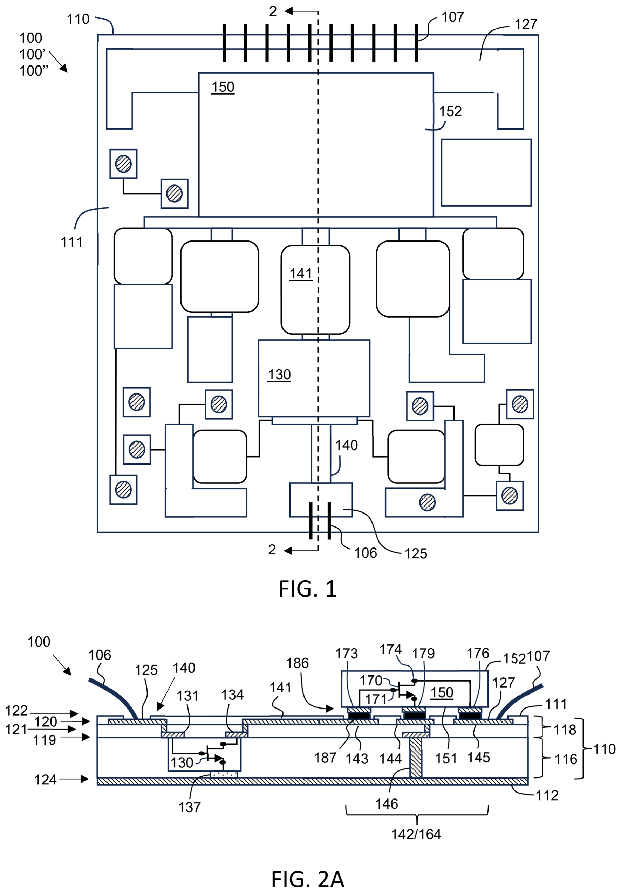

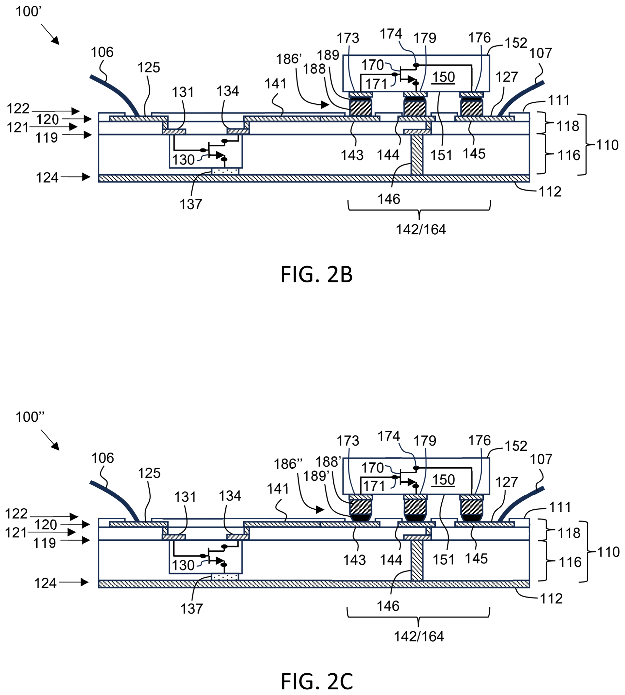

FIG. 1 illustrates a top view of a power amplifier assembly 100, 100' or 100", according to one or more embodiments. For enhanced understanding, FIG. 1 should be viewed simultaneously with FIGs 2A, 2B, and 2C, which illustrate three side, cross-sectional views of several embodiments of the power amplifier assembly 100, 100', 100" of FIG. 1 along line 2-2. Power amplifier assembly 100, 100', 100" includes a first semiconductor die 110 and a second semiconductor die 150, which are physically and electrically coupled together. As will be discussed in more detail below, the first semiconductor die 110 includes a first transistor 130 (corresponding to a first amplification stage), and the second semiconductor die 150 includes a second transistor 170 (corresponding to a second amplification stage). The first and second transistors 130, 170 are electrically coupled in a cascade arrangement to provide a two-stage power amplifier embodied in the power amplifier assembly 100, 100', 100".

Further, as will be described in detail below, the first semiconductor die 110 includes a die mounting interface 142, and the second semiconductor die 150 is "flip-chip" mounted to the die mounting interface 142. This configuration results in a power amplifier assembly 100, 100', 100" in which the first and second transistors 130, 170 of the first and second semiconductor dies 110, 150, respectively, are electrically coupled in a manner that does not require intervening circuitry on a separate PCB, as is done in conventional multiple-stage power amplifiers. As indicated above, the flip-chip connection between the first and second semiconductor dies 110, 150 results in a multiple-stage amplifier that may consume significantly smaller area (i.e., may have a significantly smaller footprint) than is needed for a conventional multiple-stage power amplifier.

The first semiconductor die 110 includes a mounting surface 111, an opposite bottom surface 112, a first-die input terminal 125, a first-die output terminal 127, a first transistor 130, and a die mounting interface 142. According to one or more embodiments, the first semiconductor die 110 also may include an interstage matching circuit 141 that is electrically coupled between the first transistor 130 and the die mounting interface 142.

The first semiconductor die 110 includes a base semiconductor substrate 116 and a build-up structure 118 formed on the base semiconductor substrate 116. The material of the base semiconductor substrate 116 classifies the first transistor 130. For example, the first transistor 130 may be a silicon-based field effect transistor (FET) (e.g., a laterally diffused metal oxide semiconductor (LDMOS) FET), or another type of FET. Accordingly, the base semiconductor substrate 116 may include one or more layers of a first semiconductor material (e.g., a material selected from silicon, silicon carbide (SiC), or other materials), according to one or more embodiments.

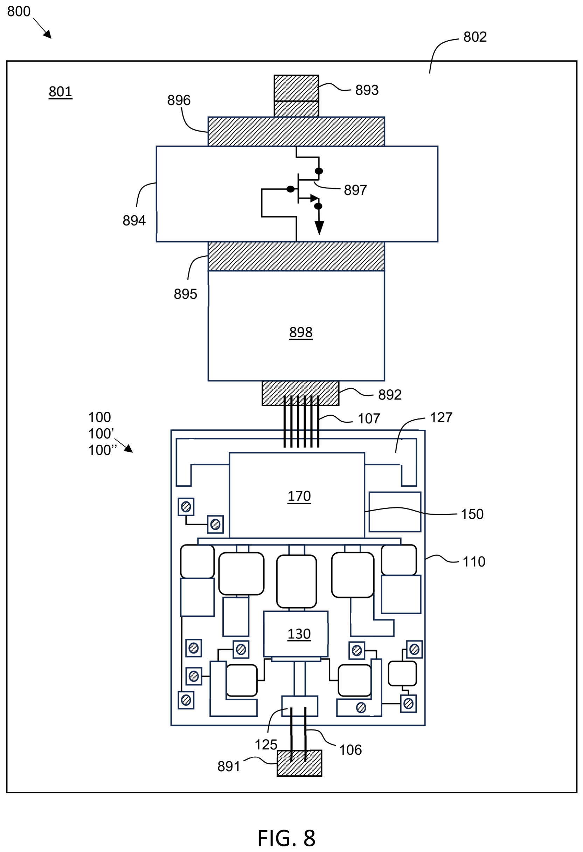

A conductive layer 124 on a bottom surface of the base semiconductor substrate 116 may function as a ground reference node for the power amplifier assembly 100, 100', 100". Ultimately, and as described later in conjunction with FIG. 8, when the power amplifier assembly 100, 100', 100" is incorporated into a larger electronic system, the conductive layer 124 may be coupled to a system ground structure, which in turn is coupled to a system ground reference voltage or to another DC voltage.

The build-up structure 118 includes a plurality of patterned conductive layers 119 and 120 interleaved with a plurality of dielectric material layers 121 and 122. Portions of different patterned conductive layers 119, 120 are electrically coupled with conductive vias. Although FIGs 2A-2C shown only two patterned conductive layers 119, 120 and two dielectric material layers 121, 122, more or fewer of either or both types of layers may be utilized to provide desired routing and connections for the first transistor 130, the interstage matching circuit 141, and the die-mounting interface 142.

The first-die input terminal 125, first-die output terminal 127, and die mounting interface 142 are exposed at the mounting surface 111 of the first semiconductor die 110. For example, the first-die input terminal 125, first-die output terminal 127, and conductive pads 143, 144, 145 of the die mounting interface 142 may be formed from portions of the uppermost patterned conductive layer 120 in the build-up structure 118. Further, the first-die input terminal 125, first-die output terminal 127, and conductive pads 143, 144, 145 of the die mounting interface 142 may be exposed through openings in the uppermost dielectric material layer 122, which may function as a solder mask, as described below.

According to an embodiment, the first-die input terminal 125 is located proximate to a first side of the first semiconductor die 110, and the first-die output terminal 127 is located proximate to an opposite second side of the semiconductor die 110. The first-die input terminal 125 and the first-die output terminal 127 each are configured for connection to first and second wirebonds 106, 107 (also referred to as input and output wirebonds 106, 107), respectively. As will be discussed in more detail in conjunction with FIG. 8, the first wirebonds 106 may have first ends (not shown in FIGs 1 or 2A-C) connected to an input signal trace of a system substrate (e.g., system substrate 801, FIG. 8), and second ends connected to the first-die input terminal 125, as shown in FIGs 1 or 2A-C. Similarly, the second wirebonds 107 may have first ends connected to the first-die output terminal 127, as shown in FIGs 1 or 2A-C, and second ends (not shown in FIGs 1 or 2A-C) connected to an output signal trace of the system substrate (e.g., system substrate 801, FIG. 8). During operation, an input signal (e.g., a radio frequency (RF) input signal) may be received through the first wirebonds 106, and an output signal (e.g., an amplified version of the RF input signal) may be provided through the second wirebonds 107.

The first transistor 130 is integrally formed within the first semiconductor die 110. More specifically, the first transistor 130 includes a first-transistor gate terminal 131 and a first-transistor drain terminal 134 formed in the build-up structure 118 (e.g., formed from portions of patterned conductive layer 119), and a plurality of doped and not-intentionally doped regions in the base semiconductor substrate 116 that correspond to drain regions (not shown), source regions (not shown), and channel regions (not shown) that are disposed between the drain and source regions. Additionally, the first transistor 130 includes a plurality of gates (not shown) in the build-up structure 118, where the gates overlie the channel regions.

The first-transistor gate terminal 131 is located proximate to the first side of the first semiconductor die 110. The first-transistor gate terminal 131 is electrically coupled to the first-die input terminal 125 through a conductive path 140 in the build-up structure 118 that includes conductive portions of the patterned conductive layers 119, 120 and conductive vias between the conductive portions.

The first-transistor drain terminal 134 is located between the first transistor 130 and the die-mounting interface 142. The drain, source, and channel regions are disposed in an active area of the die 110 between the gate and drain terminals 131, 134. Proximal ends of the gates are electrically coupled to the first-transistor gate terminal 131, and proximal ends of the drain regions are electrically coupled to the first-transistor drain terminal 134. The source regions are electrically coupled through one or more through substrate vias (TSVs) or sinker regions 137 to a ground reference node (e.g., to the conductive layer 124 on the bottom surface of the base semiconductor substrate 116). During operation, a time-varying signal applied to the first-transistor gate terminal 131 (and accordingly to the gates) alters the electrical conductivity of the underlying channel regions, causing a time-varying current to flow between the source and drain regions (and thus between the ground reference and the drain terminal 134).

As mentioned above, an interstage impedance matching circuit 141 may be electrically coupled between the first-die drain terminal 134 and the die mounting interface 142. More specifically, the impedance matching circuit 141 may be electrically coupled between the first-die drain terminal 134 and at least one first contact pad 143 of the die mounting interface 142. The interstage impedance matching circuit 141 is configured to provide impedance matching between the first transistor 130 and the second transistor 170. Various impedance matching circuits may be implemented for network 141. For example, the interstage impedance matching circuit 141 may simply include an inductor (e.g., an integrated spiral inductor or a discrete inductor coupled to the mounting surface 111 of the first semiconductor die 110. Alternatively, the interstage impedance matching circuit 141 may include a T-match network (e.g., two series inductors with a shunt capacitor coupled between the two series inductors), or another type of impedance matching circuit. In some embodiments, the interstage impedance matching circuit 141 may be excluded, and the first-die drain terminal 134 may be directly coupled to the die mounting interface 142.

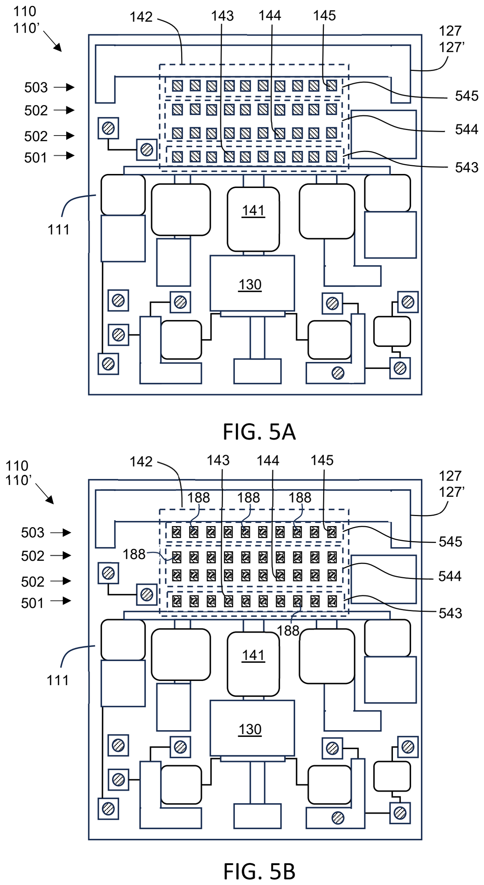

The die-mounting interface 142 is located at the mounting surface 111. The die mounting interface 142 includes the at least one first contact pad 143, at least one second contact pad 144, and at least one third contact pad 145. The first, second, and third contact pads 142, 144, 145 all are arranged within a perimeter (indicated with a dashed box referenced with number 142 in FIGs 5A and 5B). The perimeter defines the area over which the second semiconductor die 150 is flip-chip mounted to the first semiconductor die 110.

As mentioned above, the at least one first contact pad 143 is electrically coupled through a conductive path (not numbered) in the build-up structure 118 to the first-die drain terminal 134 (possibly through an interstage impedance matching circuit 141). As will be explained below, the at least one first contact pad 143 is configured to be coupled through a die-to-die interconnect system 186, 186' or 186" to at least one gate bondpad 173 of a signal and ground interface 164 of the second semiconductor die 150.

The at least one second contact pad 144 is electrically coupled through a conductive path (including one or more TSVs 146) to the conductive layer 124 at the bottom of the first semiconductor die 110 (e.g., to a ground reference node). As will be explained below, the at least one second contact pad 144 is configured to be coupled through a die-to-die interconnect system 186, 186' or 186" to at least one source bondpad 179 of a signal and ground interface 164 of the second semiconductor die 150.

The at least one third contact pad 145 is electrically coupled to the first-die output terminal 127. In some embodiments, the at least one third contact pad 145 and the first-die output terminal 127 form portions of a single conductive feature. In other embodiments, the at least one third contact pad 145 and the first-die output terminal 127 may be electrically coupled through a conductive path in the build-up structure 118. As will be explained below, the at least one third contact pad 145 is configured to be coupled through a die-to-die interconnect system 186, 186' or 186" to at least one drain bondpad 176 of a signal and ground interface 164 of the second semiconductor die 150.

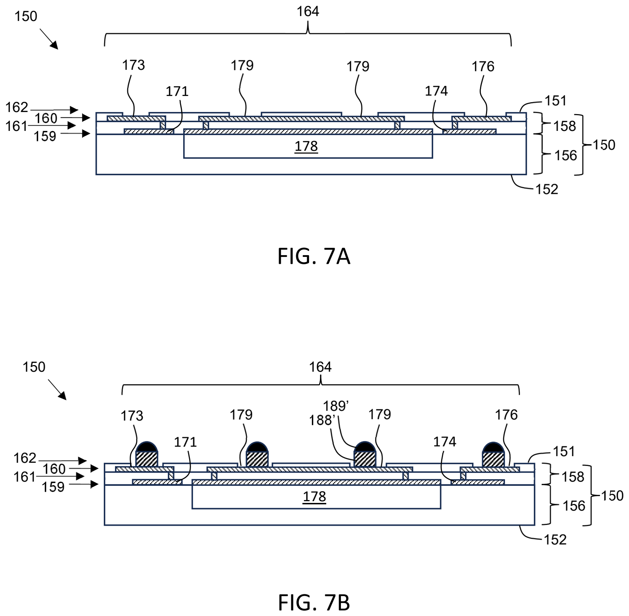

The second semiconductor die 150 includes a second-die interface surface 151, a second surface 152 opposite the second-die interface surface 151, a signal and ground interface 164, and a second transistor 170. Referring briefly to FIG. 7A, which is a side, cross-sectional view of an embodiment of the second semiconductor die 150, the second semiconductor die 150 includes a base semiconductor substrate 156 and a build-up structure 158 formed on the base semiconductor substrate 156.

The material of the base semiconductor substrate 156 classifies the second transistor 170. For example, the second transistor 170 may be a III-V FET (e.g., a gallium nitride (GaN), gallium arsenide (GaAs), gallium phosphide (GaP), indium phosphide (InP), or indium antimonide (InSb) FET), or another type of FET. Accordingly, the base semiconductor substrate 156 may include one or more layers of a second semiconductor material (e.g., a material selected from GaN, GaAs, GaP, InP, InSb), according to one or more embodiments. According to one or more embodiments, the second semiconductor material of the second semiconductor die 150 is different from the first semiconductor material of the first semiconductor die 110. According to other embodiments, the first and second semiconductor materials may be the same (e.g., the first and second semiconductor materials may include silicon, SiC, GaN, GaAs, GaP, InP, InSb, or other suitable materials).

The build-up structure 158 includes a plurality of patterned conductive layers 159 and 160 interleaved with a plurality of dielectric material layers 161 and 162. Portions of different patterned conductive layers 159, 160 are electrically coupled with conductive vias. Although FIGs 2A-2C shown only two patterned conductive layers 159, 160 and two dielectric material layers 161, 162, more or fewer of either or both types of layers may be utilized to provide desired routing and connections for the second transistor 170.

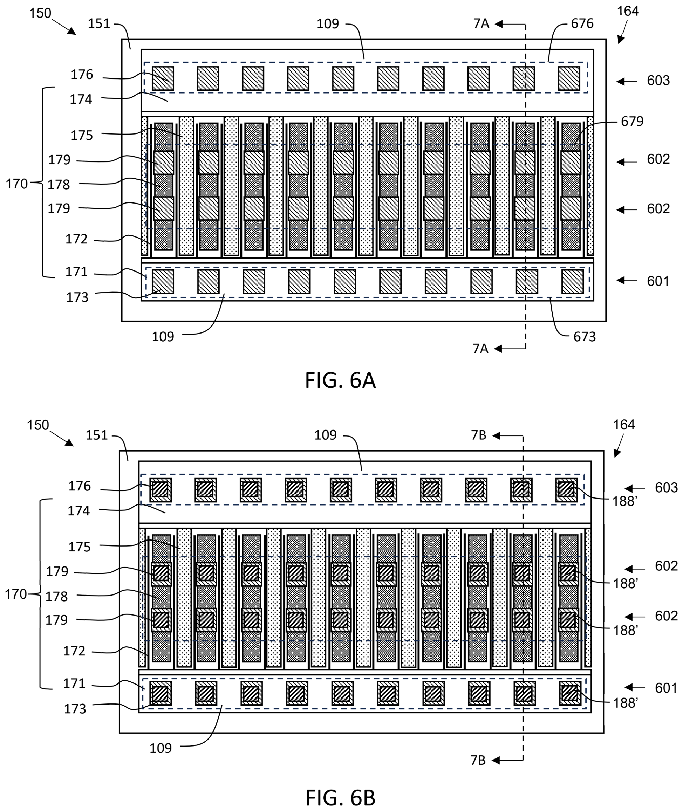

Referring also to FIGs 1, 2A, 2B, and 2C, the second transistor 170 is integrally formed within the second semiconductor die 150. More specifically, the second transistor 170 includes a second-transistor gate terminal 171 and a second-transistor drain terminal 174 formed in the build-up structure 158 (e.g., formed from portions of patterned conductive layer 159), and a plurality of doped and not-intentionally doped regions in the base semiconductor substrate 156 that correspond to drain regions (e.g., drain regions 175, FIG. 6A), source regions (e.g., source regions 178, FIG. 6A), and channel regions (not numbered) that are disposed between the drain and source regions. Additionally, the second transistor 170 includes a plurality of gates (e.g., gates 172, FIG. 6A) in the build-up structure 158, where the gates overlie the channel regions.

The second-transistor gate terminal 171 is located proximate to a first side of the second semiconductor die 150, the second-transistor drain terminal 174 is located proximate to an opposite second side of the second semiconductor die 150. The drain, source, and channel regions are disposed in an active area of the die 150 between the gate and drain terminals 171, 174. Proximal ends of the gates are electrically coupled to the second-transistor gate terminal 171, and proximal ends of the drain regions are electrically coupled to the second-transistor drain terminal 174. According to one or more embodiments, the source regions are electrically coupled to a ground reference node (e.g., the conductive layer 124) through the signal and ground interface 164, the die-to-die interconnect system 186, 186' or 186", and the first semiconductor die 110 (specifically, the second contact pads 144 of the die-mounting interface 142 and the one or more TSVs 146 of the first semiconductor die 110). During operation, a time-varying signal applied to the second-transistor gate terminal 171 (and accordingly to the gates) alters the electrical conductivity of the underlying channel regions, causing a time-varying current to flow between the source and drain regions (and thus between the ground reference and the drain terminal 174).

According to one or more embodiments, the input, output, and source-to-ground connections for the second transistor 170 are provided through the signal and ground interface 164. The signal and ground interface 164 includes a plurality of conductive pads 173, 176, 179, which are exposed at the second-die interface surface 151 of the second semiconductor die 150. The plurality of conductive pads includes at least one second-transistor gate pad 173, at least one second-transistor drain pad 176, and at least one second-transistor source pad 179.

For example, the at least one second-transistor gate pad 173, at least one second-transistor drain pad 176, and at least one second-transistor source pad 179 of the signal and ground interface 164 may be formed from portions of the uppermost patterned conductive layer (e.g., layer 160, FIG. 7A) in the build-up structure 158 (FIG. 7A). Further, the at least one second-transistor gate pad 173, at least one second-transistor drain pad 176, and at least one second-transistor source pad 179 of the signal and ground interface 164 may be exposed through openings in the uppermost dielectric material layer (e.g., layer 162, FIG. 7A), which may function as a solder mask, as described below.

To provide electrical connections between the gates, drain regions, and source regions and the conductive pads at the second-die interface surface 151, the second-transistor gate terminal 171 is coupled to the second-transistor gate pad(s) 173, the second-transistor drain terminal 174 is coupled to the second-transistor drain pad(s) 176, and the second-transistor source regions (e.g., source region 178, FIG. 7A) are coupled to the second-transistor source pad(s) 179.

As discussed above, the second semiconductor die 150 and the first semiconductor die 110 are physically and electrically coupled together through a die-to-die interconnect system (e.g., one of systems 186, 186', 186", FIGs 2A, 2B, 2C). Specifically, the signal and ground interface 164 of the second semiconductor die 150 is physically and electrically coupled to the die-mounting interface 142 of the first semiconductor die 110.

Even more specifically, as will be discussed in more detail below, through the die-to-die interconnect system 186, 186', 186", the at least one second-transistor gate pad 173 of the second semiconductor die 150 is physically and electrically coupled to the at least one first contact pad 143 of the first semiconductor die 110, the at least one second-transistor source pad 179 of the second semiconductor die 150 is physically and electrically coupled to the at least one second contact pad 144 of the first semiconductor die 110, and the at least one second-transistor drain pad 176 of the second semiconductor die 150 is physically and electrically coupled to the at least one third contact pad 145 of the first semiconductor die 110.

Embodiments of three different die-to-die interconnect systems 186, 186', 186" are shown in the cross-sectional views of FIGs 2A, 2B, and 2C. Referring first to FIG. 2A, a cross-sectional side view of a power amplifier assembly 100 is shown, which includes one or more first embodiments of the die-to-die interconnect system 186. The die-to-die interconnect system 186 includes a plurality of direct solder connections 187, including first direct solder connections between the at least one second-transistor gate pad 173 and the at least one first contact pad 143, second direct solder connections between the at least one second-transistor source pad 179 and the at least one second contact pad 144, and third direct solder connections between the at least one second-transistor drain pad 176 and the at least one third contact pad 145. As indicated above, the solder associated with the first, second, and third solder connections is controlled to avoid bridging between pads during a reflow operation by utilizing the uppermost dielectric material layers 122, 162 as solder masks.

Referring next to FIG. 2B, a cross-sectional side view of a power amplifier assembly 100' is shown, which is identical to power amplifier assembly 100 (FIG. 2A), except that the die-to-die interconnect systems 186, 186' are different. More specifically, the power amplifier assembly 100' of FIG. 2B includes one or more second embodiments of the die-to-die interconnect system 186'. Die-to-die interconnect system 186' includes a plurality of rigid conductive pillars 188 (e.g., copper pillars) with proximal ends that are rigidly connected (e.g., sintered or brazed) to the first, second, and third contact pads 143, 144, 145 of the die-mounting interface 142, along with a plurality of solder connections 189 that connect distal ends of the conductive pillars 188 to the at least one second-transistor gate pad 173, the at least one second-transistor source pad 179, and the at least one second-transistor drain pad 176.

Referring next to FIG. 2C, a cross-sectional side view of a power amplifier assembly 100" is shown, which is identical to power amplifier assembly 100 (FIG. 2A), except that the die-to-die interconnect systems 186, 186" are different. More specifically, the power amplifier assembly 100" of FIG. 2C includes one or more third embodiments of the die-to-die interconnect system 186". Die-to-die interconnect system 186" includes a plurality of rigid conductive pillars 188' (e.g., copper pillars) with proximal ends that are rigidly connected (e.g., sintered or brazed) to the at least one second-transistor gate pad 173, the at least one second-transistor source pad 179, and the at least one second-transistor drain pad 176 of the signal and ground interface 164, along with a plurality of solder connections 189' that connect distal ends of the conductive pillars 188' to the first, second, and third contact pads 143, 144, 145 of the die-mounting interface 142.

Essentially, in each of the embodiments illustrated in FIGs 2B and 2C, the die-to-die interconnect system 186', 186" includes at least one first conductive pillar 188 or 188' connected between the at least one first contact pad 143 and the at least one second-transistor gate pad 173, at least one second conductive pillar 188 or 188' connected between the at least one second contact pad 144 and the at least one second-transistor source pad 179, and at least one third conductive pillar 188 or 188' connected between the at least one third contact pad 145 and the at least one second-transistor drain pad 176.

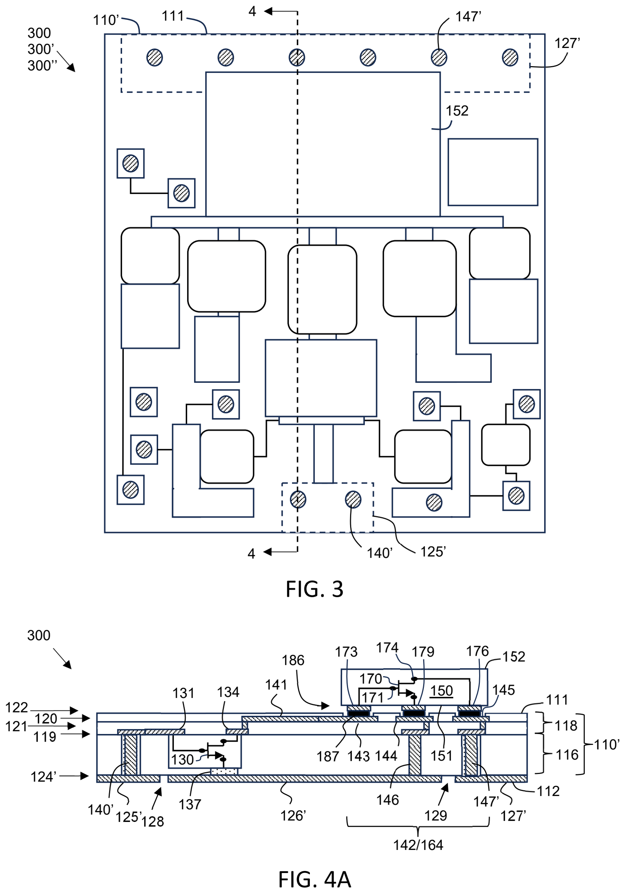

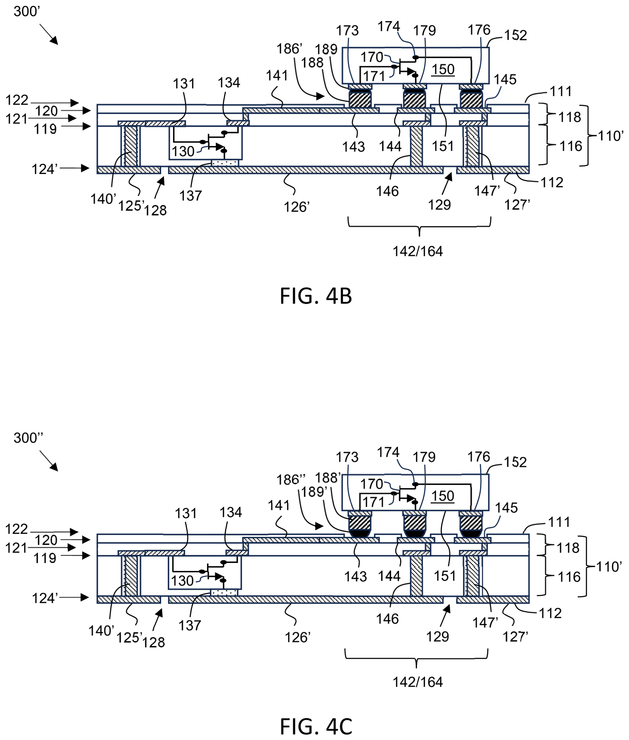

As mentioned above, and as will be discussed in more detail later in conjunction with FIG. 8, the power amplifier assemblies 100, 100', 100" of FIGs 1, 2A, 2B, and 2C are configured so that, when the assemblies 100, 100', 100" are incorporated into a larger electronic system, input wirebonds 106 and output wirebonds 107 are used to provide electrical connections with a system substrate (e.g., system substrate 801, FIG. 8) in order to receive input signals (through input wirebonds 106) and to provide output signals (through output wirebonds 107). According to one or more alternate embodiments, the first semiconductor die may be modified to instead receive input signals and provide output signals at terminals located at the bottom surface 112 of the first semiconductor die. Such embodiments will be described in detail in conjunction with FIGs 3, 4A, 4B, and 4C.

FIG. 3 illustrates a top view of a power amplifier assembly 300, 300' or 300", according to one or more embodiments. For enhanced understanding, FIG. 3 should be viewed simultaneously with FIGs 4A, 4B, and 4C, which illustrate three side, cross-sectional views of several embodiments of the power amplifier assembly 300, 300', 300" of FIG. 3 along line 4-4. Power amplifier assembly 300, 300' or 300" is similar, in many respects, to power amplifier assembly 100, 100', 100". The difference in power amplifier assembly 100, 100', 100" and power amplifier assembly 300, 300', 300" lies in differences between the first semiconductor die 110 (FIGs 1, 2A, 2B, 2C) of assembly 100, 100', 100" and the first semiconductor die 110' (FIGs 3, 4A, 4B, 4C) of assembly 300, 300', 300".

As with power amplifier assembly 100, 100', 100", power amplifier assembly 300, 300', 300" includes a first semiconductor die 110' and a second semiconductor die 150, which are physically and electrically coupled together through a die-to-die interconnect system 186, 186' or 186" (FIGs 4A, 4B, 4C). The first semiconductor die 110' includes a first transistor 130 (corresponding to a first amplification stage), and the second semiconductor die 150 includes a second transistor 170 (corresponding to a second amplification stage). The first and second transistors 130, 170 are electrically coupled in a cascade arrangement to provide a two-stage power amplifier embodied in the power amplifier assembly 300, 300', 300".

The first semiconductor die 110' in power amplifier assembly 300, 300', 300" has many similarities to the first semiconductor die 110 in power amplifier assembly 100, 100', 100". For the purpose of brevity, the detailed descriptions of similar or identical characteristics and features of the semiconductor die 110 (including various alternate embodiments) discussed above in conjunction with FIGs 1, 2A, 2B, and 2C will not be repeated here. Instead, the detailed description of the similar or identical characteristics and features of the semiconductor die 110 discussed above in conjunction with FIGs 1, 2A, 2B, and 2C are intended to be incorporated into this description of FIGs 3, 4A, 4B, and 4C.

First, the similar or identical features will be summarized. As with first semiconductor die 100 (FIGs 1, 2A, 2B, 2C), the first semiconductor die 110' includes a mounting surface 111, an opposite bottom surface 112, a first transistor 130, and a die mounting interface 142. The first transistor 130 includes a first-transistor gate terminal 131, a first-transistor drain terminal 134, and a plurality of drain regions (not shown), source regions (not shown), channel regions (not shown), and gates (not shown) overlying the channel regions. According to one or more embodiments, the first semiconductor die 110' also may include an interstage matching circuit 141 that is electrically coupled between the first transistor 130 and the die mounting interface 142. The die mounting interface 142 includes at least one first contact pad 143, at least one second contact pad 144, and at least one third contact pad 145.

The first semiconductor die 110' also includes a base semiconductor substrate 116 and a build-up structure 118 formed on the base semiconductor substrate 116. According to one or more embodiments, the first transistor 130 may be a silicon-based FET (e.g., an LDMOS FET), or another type of FET. Accordingly, the base semiconductor substrate 116 may include one or more layers of a first semiconductor material (e.g., a material selected from silicon, silicon carbide (SiC), or other materials), according to one or more embodiments. Desirably, the base semiconductor substrate 116 is formed from a high resistivity material (e.g., a high resistivity silicon material having an electrical resistivity exceeding about 520 Ω per centimeter (cm) and, perhaps, approaching or exceed 1 mega-Ω per cm).

A significant difference between the first semiconductor die 100 (FIGs 1, 2A, 2B, 2C) and the first semiconductor die 110' (FIGs 3, 4A, 4B, 4C) is that, in die 110', a first-die input terminal 125' and a first-die output terminal 127' are located at the bottom surface 112 of the first semiconductor die 110', rather than at the mounting surface 111 (as with die 110, FIGs 1, 2A, 2B, 2C).

More specifically, a conductive layer 124' on a bottom surface of the base semiconductor substrate 116 is patterned to include a first conductive feature that corresponds to a first-die input terminal 125', a second conductive feature 126' that corresponds to a ground reference node, and a third conductive feature that corresponds to a first-die output terminal 127'. According to an embodiment, the first-die input terminal 125' is located proximate to a first side of the first semiconductor die 110', and the first-die output terminal 127' is located proximate to an opposite second side of the semiconductor die 110', and the second conductive feature 126' is located between terminals 125', 127'. The first and second conductive features 125', 126' are separated by a first conductor-less region 128, and the second and third conductive features 126', 127' are separated by a second conductor-less region 129. In other words, conductive layer 124' is patterned so that the conductive features 125', 126', 127' are electrically separated across the bottom surface 112 by non-conductive gaps.

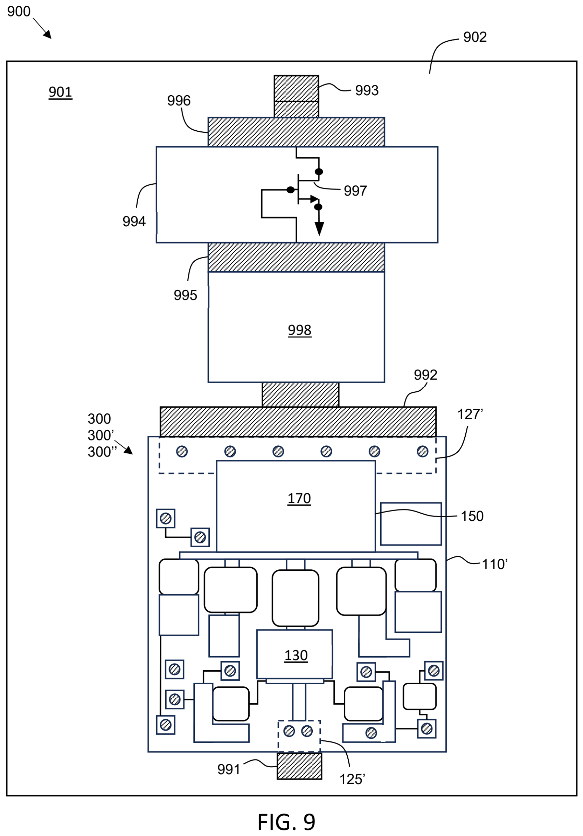

Accordingly, the first-die input terminal 125' and the first-die output terminal 127'are exposed at the bottom surface 112 of the first semiconductor die 110', rather than being exposed at the mounting surface 111. The first-die input terminal 125' and the first-die output terminal 127' each are configured to enable the first die 110' (and the power amplifier assembly 300, 300', 300") to be surface-mounted to a system substrate, and to receive and produce signals at the bottom surface 112 of the die 110'. Ultimately, and as described later in conjunction with FIG. 9, when the power amplifier assembly 300, 300', 300" is incorporated into a larger electronic system, the first conductive feature (first-die input terminal 125') may be coupled to an input terminal (e.g., terminal 991, FIG. 9), the second conductive feature 126' may be coupled to a system ground structure (which in turn is coupled to a system ground reference voltage or to another DC voltage), and the third conductive feature (first-die output terminal 127') may be coupled to an output bondpad or terminal (e.g., bondpad 992, FIG. 9).

To provide appropriate electrical connections between the first-die input terminal 125' and the first transistor 130, the base semiconductor substrate 116 includes at least one first conductive TSVs 140', which extend between the surfaces of the base semiconductor substrate 116. Because they are signal-carrying vias, the first TSV(s) 140' are insulated vias (i.e., conductive vias that are lined with a dielectric material to insulate the conductive vias from the base semiconductor substrate 116), according to one or more embodiments. As shown in FIGs 4A-4C, the first-die input terminal 125' is electrically connected to the first-transistor gate terminal 131 through the at least one first conductive TSV 140' and conductive portions of one or more of the patterned conductive layers 119, 120 of the build-up structure 118.

Similarly, to provide appropriate electrical connections between the first-die output terminal 127' and the at least one third contact pad 145 of the die mounting interface 142, the base semiconductor substrate 116 includes at least one second conductive TSV 147', which extends between the surfaces of the base semiconductor substrate 116. Again, because they are signal-carrying vias, the second TSV(s) 147' are insulated vias, according to one or more embodiments. As shown in FIGs 4A-4C, the first-die output terminal 127' is electrically connected to the at least one third contact pad 145 through the at least one second conductive TSV 147' and conductive portions of one or more of the patterned conductive layers 119, 120 of the build-up structure 118.

The first semiconductor die 110' also includes a die-mounting interface 142 at the mounting surface 111, which includes the at least one first, second, and third contact pad 143, 144, 145. Again, the first, second, and third contact pads 142, 144, 145 all are arranged within a perimeter (indicated with a dashed box referenced with number 142 in FIGs 5A and 5B). The perimeter defines the area over which the second semiconductor die 150 is flip-chip mounted to the first semiconductor die 110'.

As mentioned above, the at least one first contact pad 143 is electrically coupled to the first-die drain terminal 134 (possibly through an interstage impedance matching circuit 141, and the at least one second contact pad 144 is electrically coupled through a conductive path (including one or more TSVs 146) to the second conductive feature 126' of the conductive layer 124 at the bottom of the first semiconductor die 110' (e.g., to a ground reference node). According to one or more embodiments, the at least one third contact pad 145 is electrically coupled to the first-die output terminal 127' (through the second TSV(s) 147').

The second semiconductor die 150 in power amplifier assembly 300, 300', 300" may be identical to the second semiconductor die 150 in power amplifier assembly 100, 100', 100". For the purpose of brevity, all of the various characteristics and features of the semiconductor die 150 (including various alternate embodiments) discussed above in conjunction with FIGs 1, 2A, 2B, and 2C will not be repeated here. Instead, the detailed description of the various characteristics and features of the semiconductor die 150 discussed above in conjunction with FIGs 1, 2A, 2B, and 2C are intended to be incorporated into this description of FIGs 3, 4A, 4B, and 4C.

By way of brief summary, the second semiconductor die 150 includes a second-die interface surface 151, a second surface 152 opposite the second-die interface surface 151, a signal and ground interface 164, and a second transistor 170. Further, referring briefly to FIG. 7A, which is a side, cross-sectional view of an embodiment of the second semiconductor die 150, the second semiconductor die 150 includes a base semiconductor substrate 156 and a build-up structure 158 formed on the base semiconductor substrate 156.

Referring also to FIGs 3, 4A, 4B, and 4C, the second transistor 170 is integrally formed within the second semiconductor die 150, and the second transistor 170 includes a second-transistor gate terminal 171 and a second-transistor drain terminal 174, drain regions (e.g., drain regions 175, FIG. 6A), source regions (e.g., source regions 178, FIG. 6A), channel regions (not numbered), and a plurality of gates (e.g., gates 172, FIG. 6A) that overlie the channel regions.

Proximal ends of the gates are electrically coupled to the second-transistor gate terminal 171, and proximal ends of the drain regions are electrically coupled to the second-transistor drain terminal 174. According to one or more embodiments, the source regions are electrically coupled to a ground reference node (e.g., the conductive layer 124 of the first semiconductor die 110) through the signal and ground interface 164, the die-to-die interconnect system 186, 186' or 186", and the first semiconductor die 110' (specifically, the second contact pads 144 of the die-mounting interface 142 and the one or more TSVs 146 of the first semiconductor die 110').

According to one or more embodiments, the signal and ground interface 164 includes at least one second-transistor gate pad 173, at least one second-transistor drain pad 176, and at least one second-transistor source pad 179. To provide electrical connections between the gates, drain regions, and source regions and the conductive pads at the second-die interface surface 151, the second-transistor gate terminal 171 is coupled to the second-transistor gate pad(s) 173, the second-transistor drain terminal 174 is coupled to the second-transistor drain pad(s) 176, and the second-transistor source regions (e.g., source region 178, FIG. 7A) are coupled to the second-transistor source pad(s) 179.

Again, as discussed above, the second semiconductor die 150 and the first semiconductor die 110' are physically and electrically coupled together through a die-to-die interconnect system (e.g., one of systems 186, 186', 186", FIGs 4A, 4B, 4C). Specifically, the signal and ground interface 164 of the second semiconductor die 150 is physically and electrically coupled to the die-mounting interface 142 of the first semiconductor die 110'.

Embodiments of three different die-to-die interconnect systems 186, 186', 186" are shown in the cross-sectional views of FIGs 4A, 4B, and 4C. Referring first to FIG. 4A, a cross-sectional side view of a power amplifier assembly 300 is shown, which includes one or more first embodiments of the die-to-die interconnect system 186. The die-to-die interconnect system 186 includes a plurality of direct solder connections 187, including first direct solder connections between the at least one second-transistor gate pad 173 and the at least one first contact pad 143, second direct solder connections between the at least one second-transistor source pad 179 and the at least one second contact pad 144, and third direct solder connections between the at least one second-transistor drain pad 176 and the at least one third contact pad 145.

Referring next to FIG. 4B, a cross-sectional side view of a power amplifier assembly 300' is shown, which includes one or more second embodiments of the die-to-die interconnect system 186'. Die-to-die interconnect system 186' includes a plurality of rigid conductive pillars 188 (e.g., copper pillars) with proximal ends that are rigidly connected (e.g., sintered or brazed) to the first, second, and third contact pads 143, 144, 145 of the die-mounting interface 142, along with a plurality of solder connections 189 that connect distal ends of the conductive pillars 188 to the at least one second-transistor gate pad 173, the at least one second-transistor source pad 179, and the at least one second-transistor drain pad 176.

Referring next to FIG. 4C, a cross-sectional side view of a power amplifier assembly 300" is shown, which includes one or more third embodiments of the die-to-die interconnect system 186". Die-to-die interconnect system 186" includes a plurality of rigid conductive pillars 188' (e.g., copper pillars) with proximal ends that are rigidly connected (e.g., sintered or brazed) to the at least one second-transistor gate pad 173, the at least one second-transistor source pad 179, and the at least one second-transistor drain pad 176 of the signal and ground interface 164, along with a plurality of solder connections 189' that connect distal ends of the conductive pillars 188' to the first, second, and third contact pads 143, 144, 145 of the die-mounting interface 142.

More detailed illustrations of the first semiconductor die 110, 110' that highlight embodiments of the die-mounting interface 142 now will be described in conjunction with FIGs 5A and 5B. More particularly, FIG. 5A illustrates a top view of a first semiconductor die 110 or 110' of the power amplifier assembly 100, 100", 300, 300" of FIGs 1 or 3, 2A, 2C, 3A, and 3C, according to one or more embodiments. As discussed above in conjunction with FIGs 1, 2A, 2C, 3A, and 3C, and as shown in FIG. 5A, the first semiconductor die 110, 110' includes a die-mounting interface 142, which includes a plurality of contact pads 143-145 that are exposed at the mounting surface 111 of the first semiconductor die 110, 110'.

More particularly, the die-mounting interface 142 includes a two-dimensional array of contact pads 143-145 that includes at least one row 501 of first contact pads 143, at least one row 502 of second contact pads 144 (with two rows being shown in FIG. 5A), and at least one row 503 of third contact pads 145, all of which are contained within a perimeter (indicated with a dashed box in FIG. 5A) that defines the area over which a second semiconductor die (e.g., die 150) may be flip-chip mounted to the first semiconductor die 110, 110'.

According to some embodiments, each of the first, second, and third contact pads 143-145 may be formed from distinctly-patterned portions of the uppermost patterned conductive layer (e.g., patterned portions of layer 120, FIGs 2A, 2C, 3A, 3C) of the build-up structure of the die 110, 110'. Alternatively, some or all of the first contact pads 143 may be formed from a single first patterned conductive feature 543 of the uppermost patterned conductive layer, some or all of the second contact pads 144 may be formed from a single second patterned conductive feature 544 of the uppermost patterned conductive layer, and some or all of the third contact pads 145 may be formed from a single third patterned conductive feature 543 of the uppermost patterned conductive layer. In such embodiments, each of the first contact pads 143 may be defined as a portion of the single conductive feature 543 that is exposed through an opening in the uppermost dielectric material layer (e.g., layer 122, FIGs 2A, 2C, 3A, 3C), each of the second contact pads 144 may be defined as a portion of the single conductive feature 544 that is exposed through an opening in the uppermost dielectric material layer, and each of the third contact pads 145 may be defined as a portion of the single conductive feature 545 that is exposed through an opening in the uppermost dielectric material layer.

In such embodiments, the uppermost dielectric material layer functions as a solder mask that separates the exposed first, second, and third contact pads 143-145 from each other at the mounting surface 111 of the die 110, 110'. The solder mask function of the uppermost dielectric material layer is useful to avoid shorting pads 143-145 together when solder is applied to the exposed contact pads 143-145 and reflowed to physically couple the second semiconductor die (e.g., die 150) to the first semiconductor die 110, 110'. According to one or more embodiments, the locations of the first contact pads 143 are selected to align with corresponding gate bondpads (e.g., gate bondpads 173, FIGs 6A, 6B), the locations of the second contact pads 144 are selected to align with corresponding source bondpads (e.g., source bondpads 179, FIGs 6A, 6B), and the locations of the third contact pads 145 are selected to align with corresponding drain bondpads (e.g., drain bondpads 176, FIGs 6A, 6B) when the second die (e.g., die 150) is flip-chip mounted to the first semiconductor die 110, 110'.

As discussed above, according to one or more alternate embodiments, a plurality of conductive pillars (e.g., pillars 188, FIGs 2B, 4B) may be electrically coupled to the first, second, and third bondpads 143-145 of the die-mounting interface 142. To illustrate, FIG. 5B is a top view of a first semiconductor die 110 or 110' of the power amplifier assembly 100', 300' of FIGs 1 or 3, 2B, and 3B, according to one or more embodiments.

According to one or more embodiments, the first semiconductor die 110, 110' of FIG. 5B may be identical to the first semiconductor die 110, 110' of FIG. 5A, except that a conductive pillar 188 is coupled to each of the first, second, and third bondpads 143-145 in the first semiconductor die 110, 110' of FIG. 5B. As discussed in detail in conjunction with FIGs 2B and 4B, the conductive pillars 188 form portions of a die-to-die interconnect system 186' that is used to physically and electrically couple a second die (e.g., die 150) to the first die 110, 110'.

More detailed illustrations of the second semiconductor die 150 that highlight embodiments of the signal and ground interface 164 now will be described in conjunction with FIGs 6A and 6B. More particularly, FIG. 6A illustrates a top view of a second semiconductor die 150 of the power amplifier assembly of FIGs 1 or 3, 2A, 2B, 3A, and 3B, according to one or more embodiments. For enhanced understanding, FIG. 6A should be viewed simultaneously with FIG. 7A, which illustrates a side, cross-sectional view of the second semiconductor die 150 of FIG. 6A along line 7A-7A. As discussed above in conjunction with FIGs 1, 2A, 2B, 3A, and 3B, and as shown in FIGs 6A and 7A, the second semiconductor die 150 includes a signal and ground interface 164, which includes a plurality of gate, drain, and source pads 173, 176, 179 that are exposed at the second-die interface surface 151 of the second semiconductor die 150.

More particularly, the signal and ground interface 164 includes a two-dimensional array of contact pads 173, 176, 179 that includes at least one row 601 of gate pads 173, at least one row 602 of source pads 179 (with two rows being shown in FIG. 6A), and at least one row 603 of drain pads 176.

According to some embodiments, each of the gate, drain, and source pads 173, 176, 179 may be formed from distinctly-patterned portions of the uppermost patterned conductive layer (e.g., patterned portions of layer 160, FIG. 7A) of the build-up structure 158 of the die 150. Alternatively, some or all of the gate pads 173 may be formed from a single first patterned conductive feature 673 of the uppermost patterned conductive layer, some or all of the source pads 179 may be formed from a single second patterned conductive feature 679 of the uppermost patterned conductive layer, and some or all of the drain pads 176 may be formed from a single third patterned conductive feature 676 of the uppermost patterned conductive layer. In such embodiments, each of the gate pads 173 may be defined as a portion of the single conductive feature 673 that is exposed through an opening in the uppermost dielectric material layer (e.g., layer 162, FIG. 7A), each of the source pads 179 may be defined as a portion of the single conductive feature 679 that is exposed through an opening in the uppermost dielectric material layer, and each of the drain pads 176 may be defined as a portion of the single conductive feature 676 that is exposed through an opening in the uppermost dielectric material layer.

In such embodiments, the uppermost dielectric material layer functions as a solder mask that separates the exposed gate, drain, and source pads 173, 176, 179 from each other at the interface surface 151 of the die 150. The solder mask function of the uppermost dielectric material layer is useful to avoid shorting pads 173, 176, 179 together when solder is applied to the exposed contact pads 173, 176, 179 and reflowed to physically couple the second semiconductor die 150 to the first semiconductor die (e.g., die 110, 110'). According to one or more embodiments, the locations of the gate pads 173 are selected to align with corresponding first contact pads (e.g., pads 143, FIGs 5A, 5B), the locations of the source pads 179 are selected to align with corresponding second contact pads (e.g., pads 144, FIGs 5A, 5B), and the locations of the drain pads 176 are chosen to align with third contact pads (e.g., pads 145, FIGs 5A, 5B) when the second die 150 is flip-chip mounted to the first semiconductor die (e.g., die 110, 110', FIGs 5A, 5B).

As discussed above, according to one or more alternate embodiments, a plurality of conductive pillars (e.g., pillars 188', FIGs 2C, 4C) may be electrically coupled to the gate, drain, and source bondpads 173, 176, 179 of the signal and ground interface 164. To illustrate, FIG. 6B is a top view of a second semiconductor die 150 of the power amplifier assembly of FIGs 1 or 3, 2C, and 3C, according to one or more other embodiments. For enhanced understanding, FIG. 6B should be viewed simultaneously with FIG. 7B, which illustrates a side, cross-sectional view of the second semiconductor die 150 of FIG. 6B along line 7B-7B.

According to one or more embodiments, the second semiconductor die 150 of FIG. 6B may be identical to the second semiconductor die 150 of FIG. 6A, except that a conductive pillar 188' is coupled to each of the gate, drain, and source pads 173, 176, 179 in the second semiconductor die 150 of FIG. 6B. As discussed in detail in conjunction with FIGs 2C and 4C, the conductive pillars 188' form portions of a die-to-die interconnect system 186" that is used to physically and electrically couple the second die 150 to the first die (e.g., die 110, 110').

Examples of various amplifier systems in which the above-described power amplifier assemblies 100, 100', 100", 300, 300', 300" (FIGs 1, 2A-C, 3, 4A-C) may be incorporated will now be described in conjunction with FIGs 8-15. It should be understood that the amplifier systems discussed in conjunction with FIGs 8-15 represent only a few non-limiting examples of applications for the above-described power amplifier assemblies 100, 100', 100", 300, 300', 300" (FIGs 1, 2A-C, 3, 4A-C). Those of skill in the art would understand, based on the description herein, how to incorporate the above-described power amplifier assemblies into other types of systems.

FIG. 8 illustrates a top view of a multiple-stage amplifier system 800, according to one or more embodiments. Amplifier system 800 includes a system substrate 801, a power amplifier assembly 100, 100', 100" (e.g., any embodiment of assembly 100, 100' or 100", FIGs 1, 2A-2C), and a final-stage amplifier device 894. The system substrate 801 has a substrate mounting surface 802 and an opposite bottom surface (not shown or numbered). For example, the system substrate 801 may be a printed circuit board (PCB) or another suitable substrate.

A plurality of conductive routing traces and pads are formed on the substrate mounting surface 802. For example, the plurality of conductive routing traces and pads may include portions of a patterned conductive layer on the substrate mounting surface 802. According to one or more embodiments, the plurality of conductive routing traces and pads includes, among other features, an amplifier input terminal 891, an intermediate bondpad 892, and an amplifier output terminal 893.

According to one or more embodiments, a power amplifier assembly 100, 100', 100" (e.g., assembly 100, 100' or 100", FIGs 1, 2A-2C) is physically coupled to the substrate mounting surface 802, and electrically coupled between the amplifier input terminal 891 and the intermediate bondpad 892. The power amplifier assembly 100, 100', 100" includes a first semiconductor die 110 and a second semiconductor die 150, as described in detail in conjunction with FIGs 1 and 2A-2C).

According to one or more embodiments, to couple the power amplifier assembly 100, 100', 100" to the substrate mounting surface 802, the conductive bottom layer (e.g., layer 124, FIGs 2A-2C) of the first semiconductor die 110 of the power amplifier assembly 100, 100', 100" may be physically coupled to one or more conductive structures (e.g., traces, conductive coin(s), and/or conductive vias) in or on the system substrate 801. As indicated previously, the conductive bottom layer (e.g., layer 124, FIGs 2A-2C) may correspond to a ground refence node for the assembly 100, 100', 100", which may be coupled to a system ground reference (e.g., the above-mentioned conductive structures in the system substrate 801).

To electrically couple the power amplifier assembly 100, 100', 100" to the amplifier input terminal 891, first ends of one or more input wirebonds 106 are connected to the amplifier input terminal 891, and second ends of the input wirebond(s) 106 are connected to a first-die input terminal 125 (bondpad) of the power amplifier assembly 100, 100', 100". Similarly, to electrically couple the power amplifier assembly 100, 100', 100" to the intermediate bondpad 892, first ends of one or more output wirebonds 107 are connected to the first-die output terminal 127 (bondpad), and second ends of the output wirebond(s) 107 are connected to the intermediate bondpad 892.

The final-stage amplifier device 894 may include an input lead 895, an output lead 896, and a power transistor 897 electrically coupled between the input and output leads 895, 896. The final-stage amplifier device 894 may be coupled to the substrate mounting surface 802 by connecting the input and output leads 895, 896 to conductive pads (not numbered) at the substrate mounting surface 802. The input lead 895 may be electrically coupled to the intermediate bondpad 892 through the conductive pad to which it is coupled, and optionally, through an inter-stage matching circuit 898. The output lead 896 may be electrically coupled to the amplifier output terminal 893 through the conductive pad to which it is coupled.

The multiple-stage amplifier system 800 includes three amplification stages coupled in a cascade arrangement. More particularly, the system 800 includes a first amplification stage corresponding to the first transistor (e.g., transistor 130, FIGs 1, 2A-2C, 5A, 5B) integrated in the first semiconductor die 110, and a second amplification stage corresponding to the second transistor (e.g., transistor 170, FIGs 1, 2A-C, 6A, 6B) integrated in the second semiconductor die 150. Finally, the system 800 includes a third amplification stage corresponding to the power transistor 897 in the final-stage amplifier device 894.

Although not shown in FIG. 8, the multiple-stage amplifier system 800 also may include various bias circuits, control circuits, and other circuitry mounted to the system substrate 801 and electrically coupled to the power amplifier assembly 100, 100', 100" and/or to the final amplifier device 894.

FIG. 9 illustrates a top view of a multiple-stage amplifier system 900, according to one or more other embodiments. Amplifier system 900 includes a system substrate 901, a power amplifier assembly 300, 300', 300" (e.g., any embodiment of assembly 300, 300' or 300", FIGs 3, 4A-4C), and a final-stage amplifier device 994. The system substrate 901 has a substrate mounting surface 902 and an opposite bottom surface (not shown or numbered). For example, the system substrate 901 may be a PCB or another suitable substrate.

A plurality of conductive routing traces and pads are formed on the substrate mounting surface 902. For example, the plurality of conductive routing traces and pads may include portions of a patterned conductive layer on the substrate mounting surface 902. According to one or more embodiments, the plurality of conductive routing traces and pads includes, among other features, an amplifier input terminal 991, an intermediate bondpad 992, and an amplifier output terminal 993.

According to one or more embodiments, a power amplifier assembly 300, 300', 300" (e.g., assembly 300, 300' or 300", FIGs 3, 4A-4C) is physically coupled to the substrate mounting surface 902, and electrically coupled between the amplifier input terminal 991 and the intermediate bondpad 992. The power amplifier assembly 300, 300', 300" includes a first semiconductor die 110' and a second semiconductor die 150, as described in detail in conjunction with FIGs 3 and 4A-4C).

According to one or more embodiments, to couple the power amplifier assembly 300, 300', 300" to the substrate mounting surface 902, the conductive bottom layer (e.g., layer 124', FIGs 4A-4C) of the first semiconductor die 110' of the power amplifier assembly 300, 300', 300" may be physically coupled to one or more conductive structures (e.g., traces, conductive coin(s), and/or conductive vias) in or on the system substrate 901. As indicated previously, the conductive bottom layer (e.g., layer 124', FIGs 4A-4C) may correspond to a ground refence node for the assembly 300, 300', 300", which may be coupled to a system ground reference (e.g., the above-mentioned conductive structures in the system substrate 901).

To electrically couple the power amplifier assembly 300, 300', 300" to the amplifier input terminal 991, a first-die input terminal 125' at the bottom surface (e.g., surface 112, FIGs 4A-C) of the first semiconductor die 110' is connected (e.g., soldered) to the amplifier input terminal 991 (or to another pad coupled to terminal 991). Similarly, to electrically couple the power amplifier assembly 300, 300', 300" to the intermediate bondpad 992, a first-die output terminal 127' at the bottom surface (e.g., surface 112, FIGs 4A-C) of the first semiconductor die 110' is connected (e.g., soldered) to the intermediate bondpad 992.

The final-stage amplifier device 994 may include an input lead 995, an output lead 996, and a power transistor 997 electrically coupled between the input and output leads 995, 996. The final-stage amplifier device 994 may be coupled to the substrate mounting surface 902 by connecting the input and output leads 995, 996 to conductive pads (not numbered) at the substrate mounting surface 902. The input lead 995 may be electrically coupled to the intermediate bondpad 992 through the conductive pad to which it is coupled, and optionally, through an inter-stage matching circuit 998. The output lead 996 may be electrically coupled to the amplifier output terminal 993 through the conductive pad to which it is coupled.

The multiple-stage amplifier system 900 includes three amplification stages coupled in a cascade arrangement. More particularly, the system 900 includes a first amplification stage corresponding to the first transistor (e.g., transistor 130, FIGs 3, 4A-C, 5A, 5B) integrated in the first semiconductor die 110', and a second amplification stage corresponding to the second transistor (e.g., transistor 170, FIGs 3, 4A-C, 6A, 6B) integrated in the second semiconductor die 150. Finally, the system 900 includes a third amplification stage corresponding to the power transistor 997 in the final-stage amplifier device 994.

Although not shown in FIG. 9, the multiple-stage amplifier system 900 also may include various bias circuits, control circuits, and other circuitry mounted to the system substrate 901 and electrically coupled to the power amplifier assembly 300, 300', 300" and/or to the final amplifier device 994.

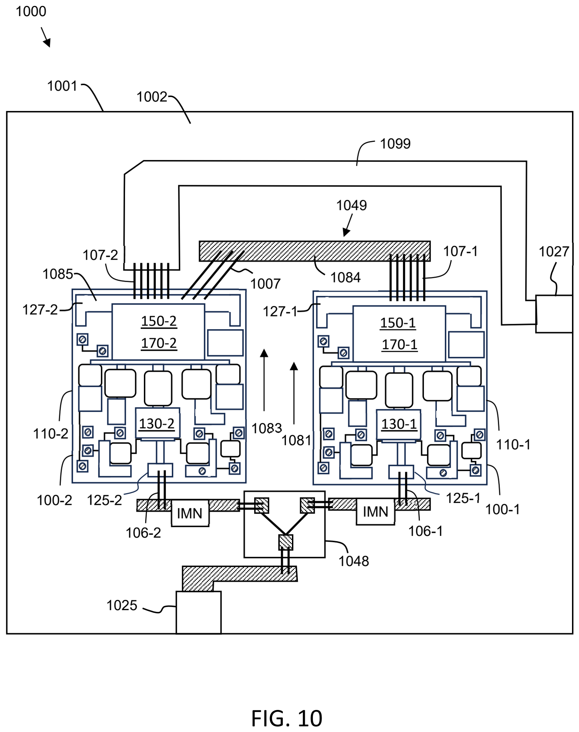

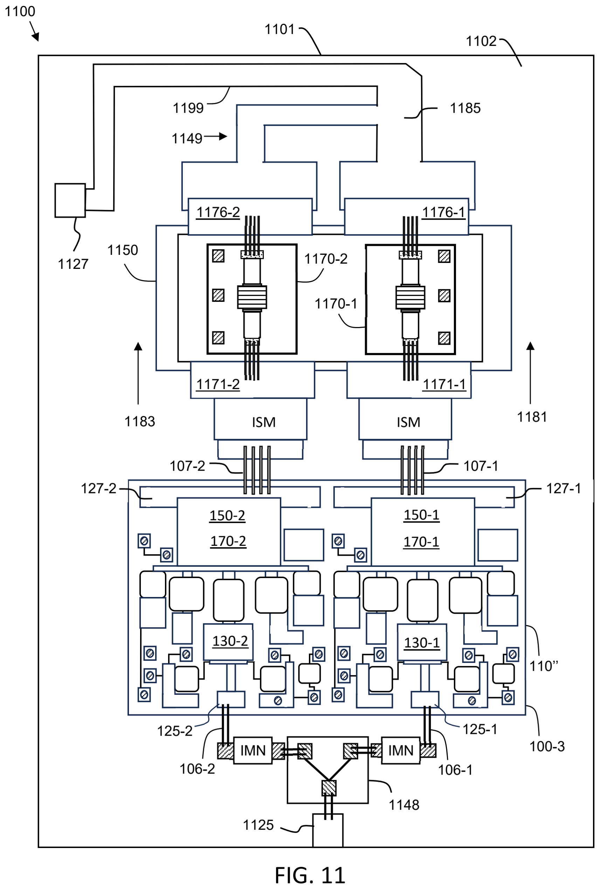

FIGs 8 and 9 depict single-path, multiple-stage power amplifiers 800, 900 into which embodiments of amplifier assemblies 100, 100', 100", 300, 300', 300" may be incorporated. In other embodiments, embodiments of amplifier assemblies 100, 100', 100", 300, 300', 300" may be incorporated into other types of power amplifiers, including multiple-path, multiple-stage power amplifiers. For example, by way of non-limiting example, embodiments of amplifier assemblies 100, 100', 100", 300, 300', 300" may be incorporated into Doherty power amplifiers, as will be discussed in conjunction with FIGs 10 and 11.

Referring first to FIG. 10, a top view of a Doherty power amplifier module 1000 is shown, which includes a first power amplifier assembly 100-1 (e.g., a first instance of any of power amplifier assemblies 100, 100', 100", FIGs 1, 2A-2C) for the carrier amplifier, and a second power amplifier assembly 100-2 (e.g., a second instance of any of power amplifier assemblies 100, 100', 100", FIGs 1, 2A-2C) for the peaking amplifier, according to one or more embodiments. Although FIG. 10 specifically illustrates power amplifier assemblies 100-1, 100-2 that include first-die input terminals 125-1, 125-2 and first-die output terminals 127-1, 127-2 configured for attachment of wirebonds 106-1, 106-2, 107-1, 107-2 (consistent with assemblies 100, 100', 100", FIGs 1, 2A-2C), it is to be understood that Doherty power amplifier module 1000 could be modified to include input and output bondpads configured to electrically couple with first-die input terminals and first-die output terminals at the bottom surface of the first and second power amplifier assemblies (e.g., module 1000 could be revised to include two instances of power amplifier assemblies 300, 300', 300", FIGs 3, 4A-4C).

Doherty power amplifier module 1000 is housed on a module substrate 1001 (e.g., a PCB or other substrate) with a module mounting surface 1002 and an opposite bottom surface (not shown or numbered). Module 1000 also includes, among other things, an amplifier input terminal 1025, a power splitter 1048, a carrier amplifier path 1081 with a carrier amplifier in the form of a first power amplifier assembly 100-1 (referred to as a "carrier amplifier assembly"), a peaking amplifier path 1083 with a peaking amplifier in the form of a second power amplifier assembly 100-2 (referred to as a "peaking amplifier assembly"), an output combining circuit 1049 with a combining node 1085, an output impedance transformer 1099, and an amplifier output terminal 1027.

Briefly, during operation of the Doherty power amplifier module 1000, the power splitter 1048 is configured to receive, at a power splitter input (not numbered), an input RF signal from the amplifier input terminal 1025. The power splitter 1048 is further configured to divide the power of the input RF signal into a carrier input signal RF and a peaking input RF signal, which are produced at first and second power splitter outputs (not numbered), respectively. In this manner, the power splitter 1048 is configured to provide a carrier input RF signal to the carrier amplification path 1081, and to provide a peaking input RF signal to the peaking amplification path 1083. According to an embodiment, the power splitter 1048 is configured to produce the carrier and peaking input RF signals with a desired phase difference (typically about 90 degrees) between the carrier and peaking input RF signals.

The carrier amplification path 1081 includes a carrier input matching network (IMN) (not numbered) and the carrier amplifier assembly 100-1. Similarly, the peaking amplification path 1083 includes a peaking IMN (not numbered) and the peaking amplifier assembly 100-2. The carrier and peaking IMNs each may include, for example, lowpass or bandpass circuits configured as T- or pi- impedance matching networks, although other matching network topologies also are anticipated. However they are configured, the IMNs incrementally increase the circuit impedance toward the source impedance.

According to one or more embodiments, and as mentioned above, the carrier amplifier is implemented as a carrier amplifier assembly 100-1 (e.g., a first instance of any of power amplifier assemblies 100, 100', 100", FIGs 1, 2A-2C), and the peaking amplifier is implemented as a peaking amplifier assembly 100-2 (e.g., a second instance of any of power amplifier assemblies 100, 100', 100", FIGs 1, 2A-2C). Accordingly, each of the carrier and peaking amplifier assemblies 100-1, 100-2 includes a first semiconductor die 110-1, 110-2 with an input terminal 125-1, 125-2, an integrated first transistor 130-1, 130-2, and an output terminal 127-1, 127-2. Each of the carrier and peaking amplifier assemblies 100-1, 100-2 also includes a second semiconductor die 150-1, 150-2 with an integrated second transistor 170-1, 170-2. Essentially, the first and second transistors 130-1, 130-2, 170-1, 170-2 are coupled in a cascade arrangement between the input terminal 125-1, 125-2 and the output terminal 127-1, 127-2. As discussed in detail in conjunction with FIGs 1 and 2A-2C, the second semiconductor die 150-1, 150-2 is flip-chip mounted to the first semiconductor die 110-1, 110-2. Further, each of the first semiconductor dies 110-1, 110-2 is coupled to the module mounting surface 1002 (e.g., conductive bottom layers 124 (or 124'), FIGs 2A, 4A are coupled to conductive features at the module mounting surface 1002).

The carrier amplifier assembly 100-1 receives the carrier input RF signal through its input terminal 125-1, provides two stages of amplification through the first and second transistors 130-1, 170-1, and produces an amplified carrier RF signal at the output terminal 127-1. Similarly, the peaking amplifier assembly 100-2 receives the peaking input RF signal through its input terminal 125-2, provides two stages of amplification through the first and second transistors 130-2, 170-2, and produces an amplified peaking RF signal at the output terminal 127-2.

The amplified carrier RF signal is then conveyed through the output combining circuit 1049 to the combining node 1085. The output combining circuit 1049 is configured to impart a phase shift to the amplified carrier RF signal (e.g., of about 90 degrees, in some embodiments) and also to provide an impedance inversion. In the illustrated embodiment, the output combining circuit 1049 includes a series-coupled circuit that includes output wirebonds 107-1 between the output terminal 127-1 of the carrier amplifier assembly 100-1 and a first end of a transmission line 1084, the transmission line 1084, and additional wirebonds 1007 between a second end of the transmission line 1084 and the combining node 1085. In the illustrated embodiment, the combining node 1085 corresponds to the output terminal 127-2 of the peaking amplifier assembly 100-2. In other embodiments, the output combining circuit 1049 and/or the combining node 1084 may be differently configured.

The amplified carrier and peaking RF signals are combined (in phase) at the combining node 1085, and conveyed through the output wirebonds 107-2 between the output terminal 127-2 of the peaking amplifier assembly 100-2 to a first end of the output impedance transformer 1099. The amplified output RF signal is then conveyed through the output impedance transformer 1099 to the amplifier output terminal 1027.

Doherty power amplifier module 1000 depicts a symmetric, non-inverted Doherty power amplifier with a 90/0 output combining circuit 1049. "Symmetric" means that a ratio of the size of the carrier amplifier to the size of the peaking amplifier is 1:1. According to other embodiments, the Doherty power amplifier module may be "asymmetric", meaning that the ratio of the size of the carrier amplifier to the size of the peaking amplifier is not 1:1 (e.g., the ratio may be 1:2 or some other value). "Non-inverted" means that the peaking input RF signal (at the input to the peaking amplifier) is delayed by about 90 degrees from the carrier input RF signal (at the input to the carrier amplifier) in order to compensate for about 90 degrees of phase delay that is applied to the amplified carrier output RF signal between the carrier amplifier output and the combining node 1085. According to other embodiments, the Doherty power amplifier module may have an "inverted" configuration in which the carrier input RF signal is delayed by about 90 degrees from the peaking input RF signal. A "90/0" output combining circuit means that approximately 90 degrees of electrical length couples the carrier amplifier intrinsic drain terminal to the combining node 1085, and approximately 0 degrees of electrical length couples the peaking amplifier intrinsic drain terminal to the combining node 1085. According to other embodiments, the Doherty power amplifier module may have an output combining circuit with different electrical lengths between the carrier and peaking amplifier intrinsic drain terminals and the combining node (e.g., the amplifier may have a 90/180 output combining circuit, or a differently configured output combining circuit).

Referring next to FIG. 11, a top view of another embodiment of a Doherty power amplifier module 1100 is shown, which includes an alternate embodiment of a power amplifier assembly 100-3 (e.g., a modified embodiment of power amplifier assemblies 100, 100', 100", FIGs 1, 2A-2C) that embodies a two-input, two-output, two-stage driver amplifier. Again, although FIG. 11 specifically illustrates a power amplifier assembly 100-3 that includes first-die input terminals 125-1, 125-2 and first-die output terminals 127-1, 127-2 configured for attachment of wirebonds 106-1, 106-2, 107-1, 107-2 (consistent with assemblies 100, 100', 100", FIGs 1,2A-2C), it is to be understood that Doherty power amplifier module 1100 could be modified to include input and output bondpads configured to electrically couple with first-die input terminals and first-die output terminals at the bottom surface of the power amplifier assembly 100-3 (e.g., module 1100 could be revised to include a modified embodiment of power amplifier assemblies 300, 300', 300", FIGs 3, 4A-4C).

Doherty power amplifier module 1100 is housed on a module substrate 1101 (e.g., a PCB or other substrate) with a module mounting surface 1102 and an opposite bottom surface (not shown or numbered). Module 1100 also includes, among other things, an amplifier input terminal 1125, a power splitter 1148, a carrier amplifier path 1181, a peaking amplifier path 1183, an output combining circuit 1149 with a combining node 1185, an output impedance transformer 1199, and an amplifier output terminal 1127. As will be described in more detail below, two-stage driver amplifiers are included along each of the carrier and peaking amplifier paths 1181, 1183, and the two-stage driver amplifiers are implemented on the power amplifier assembly 100-3. Additionally, final-stage amplifiers are included along each of the carrier and peaking amplifier paths 1181, 1183, and the final-stage amplifiers are implemented in a final-stage amplifier device 1150.

According to one or more embodiments, the power amplifier assembly 100-3 is a modified version of power amplifier assemblies 100, 100', 100", FIGs 1,2A-2C, as mentioned above. Specifically, power amplifier assembly 100-3 includes a first semiconductor die 110" and two second semiconductor dies 150-1, 150-2. The first semiconductor die 110" may be substantially identical to die 110 discussed above in conjunction with FIGs 1, 2A-2C, 5A, 5B, except that the first semiconductor die 110" of assembly 100-3 includes two, side-by-side instances (copies) of the circuitry that is included in the previously-described embodiments of die 110.

The first semiconductor die 110" is coupled to the module mounting surface 1102 (e.g., a conductive bottom layers on the bottom of die 110" is coupled to one or more conductive features at the module mounting surface 1102). Further, power amplifier assembly 110-3 includes two second semiconductor dies 150-1, 150-2 that are flip-chip mounted to the mounting surface of the first semiconductor die 110". Each of the two second semiconductor dies 150-1, 150-2 may be substantially the same as the second semiconductor dies 150 discussed in conjunction with FIGs 1, 2A-2C, 6A, 6B, 7A, and 7B.

More specifically, the power amplifier assembly 100-3 includes a first two-stage driver amplifier with an input terminal 125-1, an integrated first transistor 130-1, a second semiconductor die 150-1 with an integrated second transistor 170-1, and an output terminal 127-1. The first and second transistors 130-1, 170-1 are coupled in a cascade arrangement between the input terminal 125-1 and the output terminal 127-1. Additionally, the power amplifier assembly 110-3 includes a second two-stage driver amplifier with an input terminal 125-2, an integrated first transistor 130-2, a second semiconductor die 150-2 with an integrated second transistor 170-2, and an output terminal 127-2. The first and second transistors 130-2, 170-2 are coupled in a cascade arrangement between the input terminal 125-2 and the output terminal 127-2.

The final-stage amplifier device 1150 also may be mounted to the module mounting surface 1102. According to one or more embodiments, the final-stage amplifier device 1150 is a surface mount device that includes a package body (not numbered). Coupled to the package body, device 1150 further includes first and second input leads 1171-1, 1171-2, first and second output leads 1176-1, 1176-2, and first and second power transistors 1170-1, 1170-2 (also referred to as a final-stage carrier amplifier and a final-stage peaking amplifier, respectively). The first input lead 1171-1, the first power transistor 1170-1, and the first output lead 1176-1 form portions of the carrier amplifier path 1181. According to an embodiment, the first input lead 1171-1 is electrically coupled to an input terminal (e.g., gate terminal) of the first power transistor 1170-1, and an output terminal (e.g., drain terminal) of the first power transistor 1170-1 is electrically coupled to the first output lead 1176-1. Similarly, the second input lead 1171-2, the second power transistor 1170-2, and the second output lead 1176-2 form portions of the peaking amplifier path 1183. According to an embodiment, the second input lead 1171-2 is electrically coupled to an input terminal (e.g., gate terminal) of the second power transistor 1170-2, and an output terminal (e.g., drain terminal) of the second power transistor 1170-2 is electrically coupled to the second output lead 1176-2.

Briefly, during operation of the Doherty power amplifier module 1100, the power splitter 1148 is configured to receive, at a power splitter input (not numbered), an input RF signal from the amplifier input terminal 1125. The power splitter 1148 is further configured to divide the power of the input RF signal into a carrier input signal RF and a peaking input RF signal, which are produced at first and second power splitter outputs (not numbered), respectively. In this manner, the power splitter 1148 is configured to provide a carrier input RF signal to the carrier amplification path 1181, and to provide a peaking input RF signal to the peaking amplification path 1183. According to an embodiment, the power splitter 1148 is configured to produce the carrier and peaking input RF signals with a desired phase difference (typically about 90 degrees) between the carrier and peaking input RF signals.

The carrier amplification path 1181 includes a carrier input matching network (IMN) (not numbered), a first two-stage driver amplifier implemented in the power amplifier assembly 100-3 between input terminal 125-1 and output terminal 127-1, a carrier interstage matching network (ISM, not numbered), and a final-stage carrier amplifier 1170-1 implemented in the final-stage amplification device 1150 between input lead 1171-1 and output lead 1176-1. Similarly, the peaking amplification path 1183 includes a peaking IMN (not numbered), a second two-stage driver amplifier implemented in the power amplifier assembly 100-3 between input terminal 125-2 and output terminal 127-2, a peaking ISM (not numbered), and a final-stage peaking amplifier 1170-2 implemented in the final-stage amplification device 1150 between input lead 1171-2 and output lead 1176-2.

The carrier and peaking IMNs and the carrier and peaking ISMs each may include, for example, lowpass or bandpass circuits configured as T- or pi- impedance matching networks, although other matching network topologies also are anticipated. However they are configured, the IMNs and ISMs incrementally increase the circuit impedance.

The carrier amplification path 1181 receives the carrier input RF signal through input terminal 125-1, provides two stages of amplification through the first and second transistors 130-1, 170-1 (corresponding to the first two-stage driver amplifier in assembly 100-3), and produces an amplified carrier RF signal at the output terminal 127-1. The amplified carrier RF signal is then conveyed through the carrier ISM to the first input lead 1171-1 of the final-stage amplification device 1150. A third stage of amplification is imparted by the final-stage carrier amplifier 1170-1, and the further amplified carrier RF signal is produced at the first output lead 1176-1 of the final-stage amplification device 1150.

Similarly, the peaking amplification path 1183 receives the peaking input RF signal through input terminal 125-2, provides two stages of amplification through the first and second transistors 130-2, 170-2 (corresponding to the second two-stage driver amplifier in assembly 100-3), and produces an amplified peaking RF signal at the output terminal 127-2. The amplified peaking RF signal is then conveyed through the peaking ISM to the second input lead 1171-2 of the final-stage amplification device 1150. A third stage of amplification is imparted by the final-stage peaking amplifier 1170-2, and the further amplified peaking RF signal is produced at the second output lead 1176-2 of the final-stage amplification device 1150.

The amplified carrier and peaking RF signals are conveyed through the output combining circuit 1149 to the combining node 1185. The output combining circuit 1149 is configured to impart phase shifts to both the amplified carrier RF signal (e.g., to achieve about 90 degrees of phase shift between the drain of amplifier 1170-1 and node 1185, in some embodiments) and the amplified peaking RF signal (e.g., to achieve about 180 degrees of phase shift between the drain of amplifier 1170-2 and node 1185, in some embodiments). In addition, the output combining circuit 1149 is configured to provide an impedance inversion. The amplified carrier and peaking RF signals are combined (in phase) at the combining node 1185, and conveyed through the output impedance transformer 1199 to the amplifier output terminal 1127.

Doherty power amplifier module 1100 depicts a symmetric, non-inverted Doherty power amplifier with a 90/180 output combining circuit 1149. According to other embodiments, the Doherty power amplifier module may be asymmetric and/or inverted, and/or the output combining circuit may have different electrical lengths between the carrier and peaking amplifier intrinsic drain terminals and the combining node. In addition, although Doherty power amplifier module 1100 includes two driver amplifiers implemented on a single power amplifier assembly 100-3, alternate embodiments may utilize two separate power amplifier assemblies (e.g., two instances of assembly 100, 100', or 100", FIGs 1, 2A-2C) to provide the functionality of the two driver amplifiers.

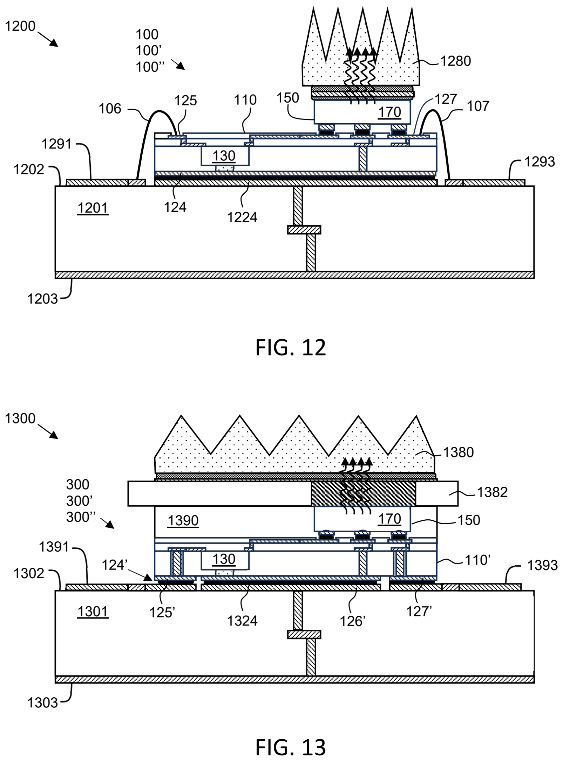

A complete amplifier design for high power applications typically needs a heat extraction system to provide a thermal path for heat generated by one or more of the power transistors in the system away from the semiconductor device(s) in which those power transistor(s) are integrated. FIGs 12-14 are included herein to provide several example embodiments of heat extraction systems that may be utilized with various embodiments of the power amplifier assemblies 100, 100', 100", 300, 300', 300", 100-1, 100-2, 100-3.

FIG. 12 illustrates a side, cross-sectional view of a multiple-stage amplifier system 1200 with a top-side cooling arrangement, according to one or more embodiments. Amplifier system 1200 includes a system substrate 1201 and a power amplifier assembly 100, 100', 100" (e.g., any embodiment of assembly 100, 100' or 100", FIGs 1, 2A-2C). The system substrate 1201 has a substrate mounting surface 1202 and an opposite bottom surface 1203. For example, the system substrate 1201 may be a PCB or another suitable substrate.

A plurality of conductive routing traces and pads are formed on the substrate mounting surface 1202. For example, the plurality of conductive routing traces and pads may include portions of a patterned conductive layer on the substrate mounting surface 1202. According to one or more embodiments, the plurality of conductive routing traces and pads includes, among other features, an amplifier input terminal 1291 and an amplifier output terminal 1293.

According to one or more embodiments, a power amplifier assembly 100, 100', 100" (e.g., assembly 100, 100' or 100", FIGs 1, 2A-2C) is physically coupled to the substrate mounting surface 1202, and electrically coupled between the amplifier input terminal 1291 and the amplifier output terminal 1293. The power amplifier assembly 100, 100', 100" includes a first semiconductor die 110 and a second semiconductor die 150, as described in detail in conjunction with FIGs 1 and 2A-2C).

According to one or more embodiments, to couple the power amplifier assembly 100, 100', 100" to the substrate mounting surface 1202, a conductive bottom layer 124 of the first semiconductor die 110 of the power amplifier assembly 100, 100', 100" may be physically coupled to a ground terminal 1224 on the mounting surface 1202 of the system substrate 1201. As indicated previously, the conductive bottom layer 124 of die 110 may correspond to a ground refence node for the assembly 100, 100', 100". According to one or more embodiments, a conductive layer (not numbered) at the bottom surface 1203 of the system substrate 1201 may correspond to a system ground reference, and the conductive bottom layer 124 of die 110 may be electrically coupled to the system ground reference through the ground terminal 1224 and one or more conductive vias (not numbered) that extend between the mounting and bottom surfaces 1202, 1203 of the system substrate 1201.

To electrically couple the power amplifier assembly 100, 100', 100" to the amplifier input terminal 1291, first ends of one or more input wirebonds 106 are connected to the amplifier input terminal 1291 (or to a trace/pad coupled to terminal 1291), and second ends of the input wirebond(s) 106 are connected to a first-die input terminal 125 (bondpad) of the power amplifier assembly 100, 100', 100". Similarly, to electrically couple the power amplifier assembly 100, 100', 100" to the amplifier output terminal 1293, first ends of one or more output wirebonds 107 are connected to the first-die output terminal 127 (bondpad), and second ends of the output wirebond(s) 107 are connected to the amplifier output terminal 1293 (or to a trace/pad coupled to terminal 1293).

The multiple-stage amplifier system 1200 includes two amplification stages coupled in a cascade arrangement. More particularly, the system 1200 includes a first amplification stage corresponding to the first transistor 130 integrated in the first semiconductor die 110, and a second amplification stage corresponding to the second transistor 170 integrated in the second semiconductor die 150.

The second transistor 170 in the second semiconductor die 150 may be a relatively high power transistor, which produces significant amounts of heat. According to one or more embodiments, to extract the heat from the second semiconductor die 150, a heat sink 1280 may be coupled to the upper surface of the second semiconductor die 150. Thermal grease (or another conductive medium) may be disposed between the upper surface of the second semiconductor die 150 and the heat sink 1280. According to one or more embodiments, the heat sink 1280 may be brought into contact with the upper surface and clamped into place. Alternatively, other methods of attachment may be used to couple the heat sink 1280 to the second semiconductor die 150.

The arrangement shown in FIG. 12 represents a top-side cooling arrangement, in which heat generated by the second semiconductor die 150 is removed by a thermal dissipation structure (e.g., a heat sink 1280) coupled to the "top" of the power amplifier assembly 100, 100', 100". A top-side cooling arrangement may be advantageous in some situations, in that it may enable the overall system in which amplifier system 1200 is incorporated to be reduced in size.

FIG. 13 illustrates a side, cross-sectional view of a multiple-stage amplifier system 1300 with a top-side cooling arrangement, according to one or more other embodiments. Amplifier system 1300 includes a system substrate 1301 and a power amplifier assembly 300, 300', 300" (e.g., any embodiment of assembly 300, 300' or 300", FIGs 3, 4A-4C). The system substrate 1301 has a substrate mounting surface 1302 and an opposite bottom surface 1303. For example, the system substrate 1301 may be a PCB or another suitable substrate.

A plurality of conductive routing traces and pads are formed on the substrate mounting surface 1302. For example, the plurality of conductive routing traces and pads may include portions of a patterned conductive layer on the substrate mounting surface 1302. According to one or more embodiments, the plurality of conductive routing traces and pads includes, among other features, an amplifier input terminal 1391, an amplifier output terminal 1393, and a ground terminal 1324 positioned between the amplifier input and output terminals 1391, 1393.

According to one or more embodiments, a power amplifier assembly 300, 300', 300" (e.g., assembly 300, 300' or 300", FIGs 3, 4A-4C) is physically coupled to the substrate mounting surface 1302, and electrically coupled between the amplifier input terminal 1391 and the amplifier output terminal 1393. The power amplifier assembly 300, 300', 300" includes a first semiconductor die 110' and a second semiconductor die 150, as described in detail in conjunction with FIGs 3 and 4A-4C). According to one or more embodiments, non-conductive encapsulant material 1390 may be disposed over the mounting surface of the first semiconductor die 110' and around the sidewalls of the second semiconductor die 150 to provide a relatively flat top surface of the assembly 300, 300', 300". Preferably, a surface of the second semiconductor die 150 is exposed at the flat top surface of assembly 300, 300', 300".

As discussed in conjunction with FIGs 3, 4A-4C, a conductive bottom layer 124' at the bottom of the power amplifier assembly 300, 300', 300" may be patterned to provide a first-die input terminal 125', a conductive feature 126' corresponding to a ground reference node, and a first-die output terminal 127'. According to one or more embodiments, to physically and electrically couple the power amplifier assembly 300, 300' or 300" to the system substrate 1301, the first-die input terminal 125' may be physically coupled (e.g., soldered) to the amplifier input terminal 1391 (or to a trace/pad coupled to terminal 1391), the first-die output terminal 127' may be physically coupled (e.g., soldered) to the amplifier output terminal 1393 (or to a trace/pad coupled to terminal 1393), and the conductive feature 126' may be physically coupled (e.g., soldered) to the ground terminal 1324. As indicated previously, the conductive feature 126' of die 110' may correspond to a ground refence node for the assembly 300, 300' or 300". According to one or more embodiments, a conductive layer (not numbered) at the bottom surface 1303 of the system substrate 1301 may correspond to a system ground reference, and the conductive feature 126' of die 110' may be electrically coupled to the system ground reference through one or more conductive vias (not numbered) that extend between the mounting and bottom surfaces 1302, 1303 of the system substrate 1301.

The multiple-stage amplifier system 1300 includes two amplification stages coupled in a cascade arrangement. More particularly, the system 1300 includes a first amplification stage corresponding to the first transistor 130 integrated in the first semiconductor die 110', and a second amplification stage corresponding to the second transistor 170 integrated in the second semiconductor die 150.

Again, the second transistor 170 in the second semiconductor die 150 may be a relatively high power transistor, which produces significant amounts of heat. According to one or more embodiments, to extract the heat from the second semiconductor die 150, an optional thermal interposer 1382 with an embedded coin (or thermal vias) and a heat sink 1380 may be coupled to the top surface of the assembly 300, 300', 300", and particularly to the exposed upper surface of the second semiconductor die 150. According to one or more embodiments, the thermal interposer 1382 (if used) and the heat sink 1380 may be brought into contact with the top surface of the assembly 300, 300', 300" and clamped into place. Alternatively, other methods of attachment may be used to couple thermal interposer 1382 (if used) and the heat sink 1380 to the assembly 300, 300', 300".

Again, the arrangement shown in FIG. 13 represents a top-side cooling arrangement, in which heat generated by the second semiconductor die 150 is removed by a thermal dissipation structure (e.g., a heat sink 1380) coupled to the "top" of the power amplifier assembly 300, 300' or 300". As mentioned previously, a top-side cooling arrangement may be advantageous in some situations, in that it may enable the overall system in which amplifier system 1300 is incorporated to be reduced in size.

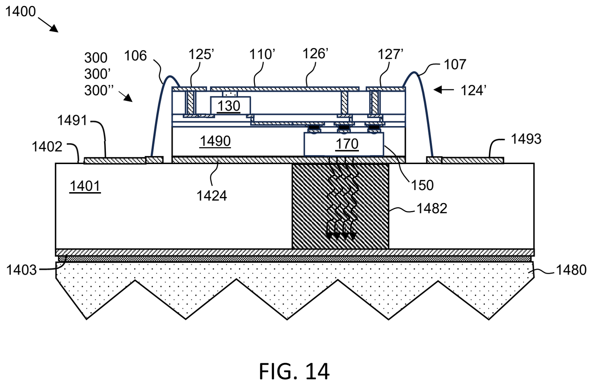

Finally, FIG. 14 illustrates a side, cross-sectional view of a multiple-stage amplifier system 1400 with a bottom-side cooling arrangement, according to one or more other embodiments. Amplifier system 1400 includes a system substrate 1401 and a power amplifier assembly 300, 300', 300" (e.g., any embodiment of assembly 300, 300' or 300", FIGs 3, 4A-4C). The system substrate 1401 has a substrate mounting surface 1402 and an opposite bottom surface 1403. For example, the system substrate 1401 may be a PCB or another suitable substrate. According to one or more embodiments, the system substrate 1401 also includes a thermally-conductive coin 1482 (or a plurality of thermal vias) that extend between the mounting and bottom surfaces 1402, 1403.

A plurality of conductive routing traces and pads are formed on the substrate mounting surface 1402. For example, the plurality of conductive routing traces and pads may include portions of a patterned conductive layer on the substrate mounting surface 1402. According to one or more embodiments, the plurality of conductive routing traces and pads includes, among other features, an amplifier input terminal 1491, an amplifier output terminal 1493, and a ground terminal 1424 positioned between the amplifier input and output terminals 1491, 1493.

According to one or more embodiments, a power amplifier assembly 300, 300', 300" (e.g., assembly 300, 300' or 300", FIGs 3, 4A-4C) is physically coupled to the substrate mounting surface 1402, and electrically coupled between the amplifier input terminal 1491 and the amplifier output terminal 1493. The power amplifier assembly 300, 300', 300" includes a first semiconductor die 110' and a second semiconductor die 150, as described in detail in conjunction with FIGs 3 and 4A-4C). According to one or more embodiments, non-conductive encapsulant material 1490 may be disposed over the mounting surface of the first semiconductor die 110' and around the sidewalls of the second semiconductor die 150 to provide a relatively flat surface of the assembly 300, 300', 300". Preferably, a surface of the second semiconductor die 150 is exposed at the flat surface of assembly 300, 300', 300".

As discussed in conjunction with FIGs 3, 4A-4C, a conductive bottom layer 124' at the bottom of the power amplifier assembly 300, 300', 300" may be patterned to provide a first-die input terminal 125', a conductive feature 126' corresponding to a ground reference node, and a first-die output terminal 127'. To physically couple the power amplifier assembly 300, 300', 300" to the system substrate 1401, the outer surface of the encapsulant material 1490 and the second semiconductor die 150 are brought into contact with the ground terminal 1424, and the assembly 300, 300', 300" and system substrate 1401 are secured together.

To electrically couple the power amplifier assembly 300, 300', 300" to the amplifier input terminal 1491, first ends of one or more input wirebonds 106 are connected to the amplifier input terminal 1491 (or to a trace/pad coupled to terminal 1491), and second ends of the input wirebond(s) 106 are connected to a first-die input terminal 125' (bondpad) of the power amplifier assembly 300, 300', 300". Similarly, to electrically couple the power amplifier assembly 300, 300', 300" to the amplifier output terminal 1493, first ends of one or more output wirebonds 107 are connected to the first-die output terminal 127' (bondpad), and second ends of the output wirebond(s) 107 are connected to the amplifier output terminal 1493 (or to a trace/pad coupled to terminal 1493).

The multiple-stage amplifier system 1400 includes two amplification stages coupled in a cascade arrangement. More particularly, the system 1400 includes a first amplification stage corresponding to the first transistor 130 integrated in the first semiconductor die 110', and a second amplification stage corresponding to the second transistor 170 integrated in the second semiconductor die 150.

Again, the second transistor 170 in the second semiconductor die 150 may be a relatively high power transistor, which produces significant amounts of heat. According to one or more embodiments, when the assembly 300, 300', 300" is coupled to the system substrate 1401, the exposed surface of the second semiconductor die 150 is brought into thermal contact with the thermally-conductive coin 1482 in the system substrate 1401. A heat sink 1480 may be coupled to (e.g., clamped to) the bottom surface 1403 of the system substrate 1401. In this manner, the arrangement shown in FIG. 14 represents a bottom-side cooling arrangement, in which heat generated by the second semiconductor die 150 is removed by a thermal dissipation structure (e.g., a heat sink 1480) coupled to the "bottom" of the system substrate 1401.

By way of summary, One or more embodiments of a power amplifier assembly include first and second semiconductor dies. The first semiconductor die is formed from a first semiconductor material, and the first semiconductor die includes a mounting surface, a first-die input terminal, a first-die output terminal, a first transistor, and a die mounting interface. The die-mounting interface is located at the mounting surface, and the die mounting interface includes at least one first contact pad, at least one second contact pad, and at least one third contact pad. The first transistor is integrally formed within the first semiconductor die, and the first transistor includes a first-transistor gate terminal electrically coupled to the first-die input terminal, and a first-transistor drain terminal electrically coupled to the at least one first contact pad of the die-mounting interface.

The second semiconductor die is formed from a second semiconductor material, and the second semiconductor die is physically and electrically coupled to the die-mounting interface at the mounting surface of the first semiconductor die. The second semiconductor die includes a second-die interface surface and a second transistor. The second transistor is integrally formed within the second semiconductor die, and the second transistor includes a second-transistor gate terminal coupled to at least one second-transistor gate pad located at the second-die interface surface, a second-transistor source region coupled to at least one second-transistor source pad located at the second-die interface surface, and a second-transistor drain terminal coupled to at least one second-transistor drain pad located at the second-die interface surface. The at least one second-transistor gate pad is physically and electrically coupled to the at least one first contact pad, the at least one second-transistor source pad is physically and electrically coupled to the at least one second contact pad, and the at least one second-transistor drain pad is physically and electrically coupled to the at least one third contact pad.

According to one or more further embodiments, a die-to-die interconnect system physically and electrically couples the first and second semiconductor dies together. According to some embodiments, the die-to-die interconnect system includes a plurality of direct solder connections between the at least one first, second, and third contact pads and the at least one second-transistor gate, source, and drain pads. According to other embodiments, the die-to-die interconnect system includes at least one first conductive pillar connected between the at least one first contact pad and the at least one second-transistor gate pad, at least one second conductive pillar connected between the at least one second contact pad and the at least one second-transistor source pad, and at least one third conductive pillar connected between the at least one third contact pad and the at least one second-transistor drain pad.

According to one or more further embodiments, the first-die input terminal is located at the mounting surface of the first semiconductor die, and includes a first bondpad configured for connection to one or more input wirebonds, and the first-die output terminal is located at the mounting surface of the first semiconductor die, and includes a second bondpad configured for connection to one or more output wirebonds.

According to one or more other embodiments, the first semiconductor die further includes first, second, and third conductive features formed from first, second, and third portions of a patterned conductive layer at the bottom surface of the first semiconductor die. The first conductive feature corresponds to the first-die input terminal, the second conductive feature corresponds to a ground reference node, and the third conductive feature corresponds to the first-die output terminal. The first and second conductive features are separated by a first conductor-less region at the bottom surface, and the second and third conductive features are separated by a second conductor-less region at the bottom surface. A first conductive through substrate via that electrically couples the first-transistor gate terminal to the first conductive feature. A second conductive through substrate via that electrically couples the at least one second contact pad to the second conductive feature. A third conductive through substrate via that electrically couples the at least one third contact pad to the third conductive feature.

One or more embodiments of a multiple-stage amplifier system include a system substrate and a power amplifier assembly. The system substrate has a substrate top surface, an amplifier input terminal, and an amplifier output terminal. The power amplifier assembly is coupled to the substrate top surface, and the power amplifier assembly includes a first semiconductor die and a second semiconductor die.

The first semiconductor die is formed from a first semiconductor material, and the first semiconductor die includes a mounting surface, a bottom surface, a first-die input terminal electrically coupled to the amplifier input terminal, a first-die output terminal electrically coupled to the amplifier output terminal, a first transistor, and a die mounting interface. The die-mounting interface is located at the mounting surface, and the die mounting interface includes at least one first contact pad, at least one second contact pad, and at least one third contact pad. The first transistor is integrally formed within the first semiconductor die, and the first transistor includes a first-transistor gate terminal electrically coupled to the first-die input terminal, and a first-transistor drain terminal electrically coupled to the at least one first contact pad of the die-mounting interface.

The second semiconductor die is formed from a second semiconductor material, and the second semiconductor die is physically and electrically coupled to the die-mounting interface at the mounting surface of the first semiconductor die. The second semiconductor die includes a second-die interface surface, a second surface opposite the second-die interface surface, and a second transistor. The second transistor is integrally formed within the second semiconductor die, and the second transistor includes a second-transistor gate terminal coupled to at least one second-transistor gate pad located at the second-die interface surface, a second-transistor source region coupled to at least one second-transistor source pad located at the second-die interface surface, and a second-transistor drain terminal coupled to at least one second-transistor drain pad located at the second-die interface. The at least one second-transistor gate pad is physically and electrically coupled to the at least one first contact pad, the at least one second-transistor source pad is physically and electrically coupled to the at least one second contact pad, and the at least one second-transistor drain pad is physically and electrically coupled to the at least one third contact pad.

The connecting lines shown in the various figures contained herein are intended to represent exemplary functional relationships and/or physical couplings between the various elements. It should be noted that many alternative or additional functional relationships or physical connections may be present in an embodiment of the subject matter. In addition, certain terminology may also be used herein for the purpose of reference only, and thus are not intended to be limiting, and the terms "first," "second" and other such numerical terms referring to structures do not imply a sequence or order unless clearly indicated by the context.

As used herein, a "node" means any internal or external reference point, connection point, junction, signal line, conductive element, or the like, at which a given signal, logic level, voltage, data pattern, current, or quantity is present. Furthermore, two or more nodes may be realized by one physical element (and two or more signals can be multiplexed, modulated, or otherwise distinguished even though received or output at a common node).

The foregoing description refers to elements or nodes or features being "connected" or "coupled" together. As used herein, unless expressly stated otherwise, "connected" means that one element is directly joined to (or directly communicates with) another element, and not necessarily mechanically. Likewise, unless expressly stated otherwise, "coupled" means that one element is directly or indirectly joined to (or directly or indirectly communicates with, electrically or otherwise) another element, and not necessarily mechanically. Thus, although the schematic shown in the figures depict one exemplary arrangement of elements, additional intervening elements, devices, features, or components may be present in an embodiment of the depicted subject matter.

As used herein, the words "exemplary" and "example" mean "serving as an example, instance, or illustration." Any implementation described herein as exemplary or an example is not necessarily to be construed as preferred or advantageous over other implementations. Furthermore, there is no intention to be bound by any expressed or implied theory presented in the preceding technical field, background, or detailed description.

While at least one exemplary embodiment has been presented in the foregoing detailed description, it should be appreciated that a vast number of variations exist. It should also be appreciated that the exemplary embodiment or embodiments described herein are not intended to limit the scope, applicability, or configuration of the claimed subject matter in any way. Rather, the foregoing detailed description will provide those skilled in the art with a convenient road map for implementing the described embodiment or embodiments. It should be understood that various changes can be made in the function and arrangement of elements without departing from the scope defined by the claims, which includes known equivalents and foreseeable equivalents at the time of filing this patent application.

## Claims

1. A power amplifier assembly comprising:
a first semiconductor die formed from a first semiconductor material, the first semiconductor die including a mounting surface, a first-die input terminal, a first-die output terminal, a first transistor, and a die mounting interface, wherein
the die-mounting interface is located at the mounting surface, and the die mounting interface includes at least one first contact pad, at least one second contact pad, and at least one third contact pad, and
the first transistor is integrally formed within the first semiconductor die, and the first transistor includes a first-transistor gate terminal electrically coupled to the first-die input terminal, and a first-transistor drain terminal electrically coupled to the at least one first contact pad of the die-mounting interface; and
a second semiconductor die formed from a second semiconductor material, wherein the second semiconductor die is physically and electrically coupled to the die-mounting interface at the mounting surface of the first semiconductor die, and the second semiconductor die includes a second-die interface surface and a second transistor, wherein
the second transistor is integrally formed within the second semiconductor die, and the second transistor includes a second-transistor gate terminal coupled to at least one second-transistor gate pad located at the second-die interface surface, a second-transistor source region coupled to at least one second-transistor source pad located at the second-die interface surface, and a second-transistor drain terminal coupled to at least one second-transistor drain pad located at the second-die interface surface,
the at least one second-transistor gate pad is physically and electrically coupled to the at least one first contact pad,
the at least one second-transistor source pad is physically and electrically coupled to the at least one second contact pad, and
the at least one second-transistor drain pad is physically and electrically coupled to the at least one third contact pad.

2. The power amplifier assembly of claim 1, wherein:
the first semiconductor material of the first semiconductor die is selected from a group of semiconductor materials consisting of silicon and silicon carbide; and
the second semiconductor material of the second semiconductor die is selected from a group of semiconductor materials consisting of gallium nitride, gallium arsenide, gallium phosphide, indium phosphide, and indium antimonide.

3. The power amplifier assembly of claim 1 or 2, further comprising:
a die-to-die interconnect system that physically and electrically couples the first and second semiconductor dies together, wherein the die-to-die interconnect system includes a plurality of direct solder connections between the at least one first, second, and third contact pads and the at least one second-transistor gate, source, and drain pads.

4. The power amplifier assembly of any preceding claim, further comprising:
a die-to-die interconnect system that physically and electrically couples the first and second semiconductor dies together, wherein the die-to-die interconnect system includes
at least one first conductive pillar connected between the at least one first contact pad and the at least one second-transistor gate pad,
at least one second conductive pillar connected between the at least one second contact pad and the at least one second-transistor source pad, and
at least one third conductive pillar connected between the at least one third contact pad and the at least one second-transistor drain pad.

5. The power amplifier assembly of any preceding claim, wherein the first semiconductor die further comprises:
a bottom surface opposite the mounting surface;
a ground reference node at the bottom surface; and
a conductive through substrate via that electrically couples the at least one second contact pad to the ground reference node.

6. The power amplifier assembly of claim 5, wherein:
the ground reference node includes a conductive layer at the bottom surface of the first semiconductor die;
the first-die input terminal is located at the mounting surface of the first semiconductor die, and includes a first bondpad configured for connection to one or more input wirebonds; and
the first-die output terminal is located at the mounting surface of the first semiconductor die, and includes a second bondpad configured for connection to one or more output wirebonds.

7. The power amplifier assembly of claim 6, wherein:
the second bond pad and the at least one third contact pad form portions of a single conductive feature.

8. The power amplifier assembly of claim 5 or 6, wherein the first semiconductor die further comprises:
a first conductive feature formed from a first portion of a patterned conductive layer at the bottom surface of the first semiconductor die, wherein the first conductive feature corresponds to the first-die input terminal;
a second conductive feature formed from a second portion of the patterned conductive layer, wherein the first and second conductive features are separated by a first conductor-less region at the bottom surface, and wherein the second conductive feature corresponds to the ground reference node;
a third conductive feature formed from a third portion of the patterned conductive layer, wherein the second and third conductive features are separated by a second conductor-less region at the bottom surface, and wherein the third conductive feature corresponds to the first-die output terminal;
a first conductive through substrate via that electrically couples the first-transistor gate terminal to the first conductive feature;
a second conductive through substrate via that electrically couples the at least one second contact pad to the second conductive feature; and
a third conductive through substrate via that electrically couples the at least one third contact pad to the third conductive feature.

9. The power amplifier assembly of claim 8, wherein:
the first conductive through substrate via is lined with a dielectric material; and
the third conductive through substrate via is lined with the dielectric material.

10. The power amplifier assembly of any preceding claim1, wherein the first semiconductor die further comprises:
an impedance matching circuit electrically connected between the first-transistor drain terminal and the at least one first contact pad of the die-mounting interface.

11. A multiple-stage amplifier system comprising:
a system substrate including a substrate top surface, an amplifier input terminal, and an amplifier output terminal;
a power amplifier assembly coupled to the substrate top surface, wherein the power amplifier assembly includes a first semiconductor die and a second semiconductor die, and wherein
the first semiconductor die is formed from a first semiconductor material, and the first semiconductor die includes a mounting surface, a bottom surface, a first-die input terminal electrically coupled to the amplifier input terminal, a first-die output terminal electrically coupled to the amplifier output terminal, a first transistor, and a die mounting interface, wherein
the die-mounting interface is located at the mounting surface, and the die mounting interface includes at least one first contact pad, at least one second contact pad, and at least one third contact pad, and
the first transistor is integrally formed within the first semiconductor die, and the first transistor includes a first-transistor gate terminal electrically coupled to the first-die input terminal, and a first-transistor drain terminal electrically coupled to the at least one first contact pad of the die-mounting interface; and
the second semiconductor die is formed from a second semiconductor material, wherein the second semiconductor die is physically and electrically coupled to the die-mounting interface at the mounting surface of the first semiconductor die, and the second semiconductor die includes a second-die interface surface, a second surface opposite the second-die interface surface, and a second transistor, wherein
the second transistor is integrally formed within the second semiconductor die, and the second transistor includes a second-transistor gate terminal coupled to at least one second-transistor gate pad located at the second-die interface surface, a second-transistor source region coupled to at least one second-transistor source pad located at the second-die interface surface, and a second-transistor drain terminal coupled to at least one second-transistor drain pad located at the second-die interface,
the at least one second-transistor gate pad is physically and electrically coupled to the at least one first contact pad,
the at least one second-transistor source pad is physically and electrically coupled to the at least one second contact pad, and
the at least one second-transistor drain pad is physically and electrically coupled to the at least one third contact pad.

12. The multiple-stage amplifier system of claim 11, wherein:
the first semiconductor material of the first semiconductor die is selected from a group of semiconductor materials consisting of silicon and silicon carbide; and
the second semiconductor material of the second semiconductor die is selected from a group of semiconductor materials consisting of gallium nitride, gallium arsenide, gallium phosphide, indium phosphide, and indium antimonide.

13. The multiple-stage amplifier system of claim 11 or 12, wherein:
the power amplifier assembly is coupled to the substrate top surface so that the bottom surface of the first semiconductor die faces the substrate top surface.

14. The multiple-stage amplifier system of claim 13, wherein the power amplifier assembly further comprises:
encapsulant material over the mounting surface of the first semiconductor die and surrounding sidewalls of the second semiconductor die, wherein the second surface of the second semiconductor die is exposed at a top surface of the encapsulant material; and
a thermal dissipation structure coupled to the top surface of the encapsulant material and the second surface of the second semiconductor die.

15. The multiple-stage amplifier system of claim 13 or 14, wherein:
the system substrate further includes a ground reference pad at the substrate top surface between the amplifier input pad and the amplifier output pad; and
the first semiconductor die further includes
a first conductive feature formed from a first portion of a patterned conductive layer at the bottom surface of the first semiconductor die, wherein the first conductive feature corresponds to the first-die input terminal,
a second conductive feature formed from a second portion of the patterned conductive layer, wherein the first and second conductive features are separated by a first conductor-less region at the bottom surface, wherein the second conductive feature corresponds to the ground reference node, and wherein the second conductive feature is coupled to the ground reference pad of the system substrate,
a third conductive feature formed from a third portion of the patterned conductive layer, wherein the second and third conductive features are separated by a second conductor-less region at the bottom surface, and wherein the third conductive feature corresponds to the first-die output terminal,
a first conductive through substrate via that electrically couples the first-transistor gate terminal to the first conductive feature,
a second conductive through substrate via that electrically couples the at least one second contact pad to the second conductive feature, and
a third conductive through substrate via that electrically couples at least one third contact pad to the third conductive feature.
